# EUROPEAN PATENT APPLICATION

(11) **EP 4 672 893 A1**
(43) Date of publication of application: **31.12.2025**
(21) Application number: 25183394.3
(22) Date of filing: 17.06.2025
(51) Int. Cl.: H10B 12/00, G11C 5/06, G11C 8/14, G11C 11/408

(54) **SEMICONDUCTOR MEMORY DEVICES**

(30) Priority: 28.06.2024 KR 20240085506
(71) Applicant: Samsung Electronics Co., Ltd., Suwon-si, Gyeonggi-do 16677 (KR)
(72) Inventor: KIM, Yujin, 16677 Suwon-si (KR); HAN, Jinwoo, 16677 Suwon-si (KR); YOO, Bowon, 16677 Suwon-si (KR)
(74) Representative: Marks & Clerk LLP

(57) **Abstract**

A semiconductor memory device may include a substrate including a stack region and a pad region in a first horizontal direction, word lines extending in the first horizontal direction in the stack region, bit lines extending in a vertical direction in the stack region and spaced apart from one another in the first horizontal direction and a second horizontal direction, memory cells in the stack region and between the word lines and the bit lines, and a pad structure including word line pads spaced apart from each other in the vertical direction in the pad region. The word lines may include first and second word lines, which may be separated from each other in the second horizontal direction. The first and second horizontal directions may different. Each of the word line pads may be connected to the first and second words lines at a same vertical level.

## Description

### BACKGROUND

Inventive concepts relate to a semiconductor memory device, and more particularly, to a three-dimensional (3D) semiconductor memory device including a plurality of memory cells arranged in three dimensions.

With the demand for compact and multifunctionalized high-performance electronic products, higher-capacity semiconductor memory devices may be required. To provide higher-capacity semiconductor memory devices, there may be demand for an increase in integration density. Because the integration density of semiconductor memory devices including a plurality of memory cells arranged in two dimensions according to the related art mainly may depend on an area occupied by a memory cell, the integration density of two-dimensional (2D) semiconductor memory devices still may be limited, although the integration density may be increasing. Therefore, 3D semiconductor memory devices, which may increase memory capacity by stacking memory cells on a substrate in the vertical direction to include a plurality of memory cells arranged in three dimensions, have been suggested.

### SUMMARY

Inventive concepts provide a three-dimensional (3D) semiconductor memory device having an increased integration density.

According to an embodiment of inventive concepts, a semiconductor memory device may include a substrate including a stack region and a pad region in a first horizontal direction; a plurality of word lines extending in the first horizontal direction in the stack region and spaced apart from each other in a vertical direction, the plurality of word lines including a first word line and a second word line at a same vertical level, the first word line and the second word line being separated from each other in a second horizontal direction, the second horizontal direction being different from the first horizontal direction; a plurality of bit lines extending in the vertical direction in the stack region and spaced apart from one another in the first horizontal direction and the second horizontal direction; a plurality of memory cells in the stack region, the plurality of memory cells being between the plurality of word lines and the plurality of bit lines; and a pad structure including a plurality of word line pads spaced apart from each other in the vertical direction in the pad region. Each of the plurality of word line pads may be connected to the first word line and the second word line at the same vertical level.

The stack region and the pad region may be arranged in the first horizontal direction. At each of a plurality of vertical levels, one or more word line pads may be positioned, and each of the word line pads may be connected to a corresponding pair of word lines (a first word line and a second word line) that are separated from each other in the second horizontal direction.

A vertical level may be a level measured along the vertical direction (e.g. a direction in which the bit lines extend). The vertical direction may be perpendicular to a first surface (e.g. an upper surface) of the substrate. The bit lines may be arranged on the first surface of the substrate.

The substrate may comprise a plurality of stack regions, including a first stack region and a second stack region respectively at opposite sides of the pad region in the first horizontal direction. Each of the first and second stack regions may comprise first and second word lines. Each of the plurality of word line pads may be connected to first and second word lines in both the first stack region and the second stack region. For each word line pad, the first and second word lines connected to the word line pad may be arranged at the same vertical level as the word line pad.

According to an embodiment, a width of each of the plurality of word line pads in the second horizontal direction is greater than a distance in the second horizontal direction between one side surface of the first word line among both side surfaces thereof and one side surface of the second word line among both side surfaces thereof, wherein the one side surface of the first word line is opposite to the one side surface of the second word line.

According to an embodiment, for each word line pad, a width of word line pad in the second horizontal direction is greater than a distance in the second horizontal direction between a first side surface of the first word line connected to the word line pad, and a second side surface of the second word line connected to the word line pad, wherein the first side surface of the first word line is opposite to the second side surface of the second word line.

According to an embodiment, the plurality of bit lines include bit line columns spaced apart from each other in the second horizontal direction, each of the bit line columns includes some bit lines among the plurality of bit lines, the some bit lines being arranged in a column in the first horizontal direction, the first word line, the second word line, and one bit line column among the bit line columns are repeatedly arranged in the second horizontal direction, and, in a plan view, the plurality of bit lines are not arranged between a first word line and a second word line which are connected to the same word line pad.

According to an embodiment, the plurality of bit lines include a plurality of bit line columns spaced apart from each other in the second horizontal direction, each of the plurality of bit line columns includes some bit lines among the plurality of bit lines, the some bit lines being arranged in a column in the first horizontal direction, and, in a plan view, a pair of bit line columns among the plurality of bit line columns is arranged between a first word line and a second word line which are connected to the same word line pad.

According to an embodiment of inventive concepts, a semiconductor memory device may include a substrate including a plurality of stack regions and a plurality of pad regions alternately arranged with each other in a first horizontal direction, the plurality of stack regions including a first stack region and a second stack region respectively at opposite sides in the first horizontal direction of one pad region among the plurality of pad regions; a plurality of word lines extending in the first horizontal direction in each of the plurality of stack regions and spaced apart from each other in a vertical direction, the plurality of word lines including a first word line and a second word line at a same vertical level, the first word line and the second word line being separated from each other in a second horizontal direction, the second horizontal direction being different from the first horizontal direction; a plurality of bit lines extending in the vertical direction in each of the plurality of stack regions and spaced apart from one another in the first horizontal direction and the second horizontal direction; a plurality of memory cells in each of the plurality of stack regions, the plurality of memory cells being between the plurality of word lines and the plurality of bit lines; a pad structure including a plurality of word line pads spaced apart from each other in the vertical direction in each of the plurality of pad regions; and a plurality of word line contacts in each of the plurality of pad regions and electrically connected to the plurality of word line pads, respectively. Each of the plurality of word line pads may be connected to the first word line and the second word line at the same vertical level in at least one of the first stack region and the second stack region.

According to an embodiment of inventive concepts, a semiconductor memory device may include a lower structure; and an upper structure on the lower structure, the upper structure including a plurality of sub-word line drivers. The lower structure may include a substrate including a plurality of stack regions and a plurality of pad regions alternately arranged with each other in a first horizontal direction, the plurality of stack regions including a first stack region and a second stack region respectively at opposite sides in the first horizontal direction of one pad region among the plurality of pad regions; a plurality of word lines extending in the first horizontal direction in each of the plurality of stack regions and spaced apart from each other in a vertical direction, the plurality of word lines including a first word line and a second word line at a same vertical level, the first word line and the second word line being separated from each other in a second horizontal direction, the second horizontal direction being different from the first horizontal direction; a plurality of bit lines extending in the vertical direction in each of the plurality of stack regions and spaced apart from each other in the first horizontal direction; a plurality of memory cells in each of the plurality of stack regions, the plurality of memory cells being between the plurality of word lines and the plurality of bit lines; a pad structure including a plurality of word line pads spaced apart from each other in the vertical direction in each of the plurality of pad regions; and a plurality of word line contacts in each of the plurality of pad regions and electrically connecting the plurality of word line pads to the plurality of sub-word line drivers. Each of the plurality of word line pads may be connected to the first word line and the second word line, which may be arranged at the same vertical level in each of the first stack region and the second stack region. Each of the plurality of memory cells may include a cell transistor and an information storage element. The cell transistor may include a semiconductor pattern passing through one of the plurality of word lines. The semiconductor pattern may include a source region connected to each of the plurality of bit lines, a channel region surrounded by each of the plurality of word lines, and a drain region connected to the information storage element. The source region, the channel region, and the drain region may be sequentially arranged from each of the plurality of bit lines in the second horizontal direction.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is an equivalent circuit diagram of a stacked cell array of a semiconductor memory device, according to embodiments;
FIG. 2 is a block diagram illustrating a semiconductor memory device according to embodiments;
FIGS. 3A and 3B are respectively a perspective view and a plan view of a semiconductor memory device according to embodiments;
FIGS. 4A to 4C are a perspective view and cross-sectional views illustrating a part of a semiconductor memory device, according to embodiments;
FIG. 5A is a plan view illustrating a semiconductor memory device according to embodiments, and FIG. 5B is a plan view illustrating a part of a semiconductor memory device according to embodiments;
FIGS. 6A to 6C are cross-sectional views each illustrating a part of a semiconductor memory device according to embodiments;
FIGS. 7A to 7E are plan views each illustrating a word line pad and word line contacts of a semiconductor memory device, according to embodiments;
FIG. 8A is a perspective view of a semiconductor memory device according to embodiments, FIG. 8B is a plan view illustrating a part of a semiconductor memory device, according to embodiments, and FIG. 8C is a plan view of a semiconductor memory device according to embodiments;
FIG. 9 is a block diagram of a row decoder included in a semiconductor memory device, according to embodiments;
FIG. 10 is a circuit diagram of a sub-word line driver circuit in FIG. 9;
FIG. 11 is an equivalent circuit diagram of a memory cell array of a semiconductor memory device, according to embodiments;
FIGS. 12A and 12B are respectively a perspective view and a cross-sectional view of a part of a semiconductor memory device, according to embodiments; and
FIGS. 13 and 14 are plan views each illustrating a part of a semiconductor memory device, according to embodiments.

### DETAILED DESCRIPTION

Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

The notion that elements are "substantially the same" may indicate that the element may be completely the same and may also indicate that the elements may be determined to be the same in consideration of errors or deviations occurring during a process.

As used herein, the singular forms "a", "an", and "the" are intended to include the plural forms as well, unless the context clearly indicates otherwise. Additionally, the description may be specific to a portion of the semiconductor memory device and the described structure may be repeated in other portions of the semiconductor memory device. For example, the described structure may be an individual element of an array of elements forming the semiconductor memory device. Accordingly, where the structure of a single element of a plurality of elements has been described, this structure may equally apply to other elements of the plurality of elements.

Embodiments described herein provide improved means of arranging word line contacts that enables increased integration density and reduces the risk of short-circuits.

In a memory (e.g. a dynamic random-access memory (DRAM)) structure in which memory cells are arranged in two dimensions, scaling is continuously carried out to increase integration density because the integration density mainly depends on an area occupied by a memory cell, but the integration density is still limited. Therefore, vertically stacked three-dimensional (3D) semiconductor memory devices (e.g. vertically stacked DRAM (VS-DRAM)) increasing memory capacity by stacking a plurality of memory cells on a substrate in the vertical direction, has been developed.

When a plurality of word lines included in a 3D semiconductor memory device are not formed in a stair pattern, the area of a pad region, in which a word line pad is located to connect a contact to each of the word lines, is reduced, and accordingly, the integration density of the memory device may increase. However, when the contact is formed to pass through the word lines stacked in the vertical direction, the horizontal width of the contact increases, and accordingly, there may be a problem of a bridge between the contact and another word line adjacent to the contact in a horizontal direction.

According to embodiments described herein, a pair of word line pads respectively connected to two word lines may be merged into a single word line pad so that the two word lines share one contact adjacent to the two word lines in a horizontal direction. Accordingly, the area of the word line pad increases, allowing the contact to have a relatively large horizontal width, and thus, a bridge may be prevented from occurring between the contact and another word line adjacent to the contact in the horizontal direction.

In addition, the larger size of the word line contact pads allow the contacts to be arranged in a variety of patterns (e.g. including multiple rows), such as in a matrix or honeycomb pattern, further reducing the area of a pad region.

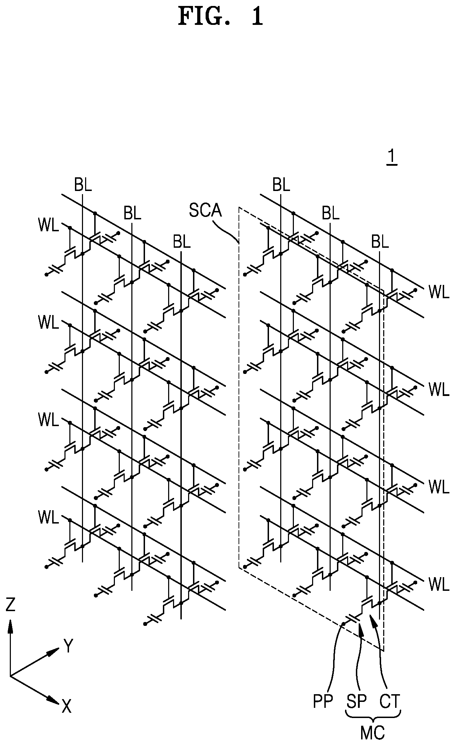

FIG. 1 is an equivalent circuit diagram of a stacked cell array of a semiconductor memory device, according to embodiments.

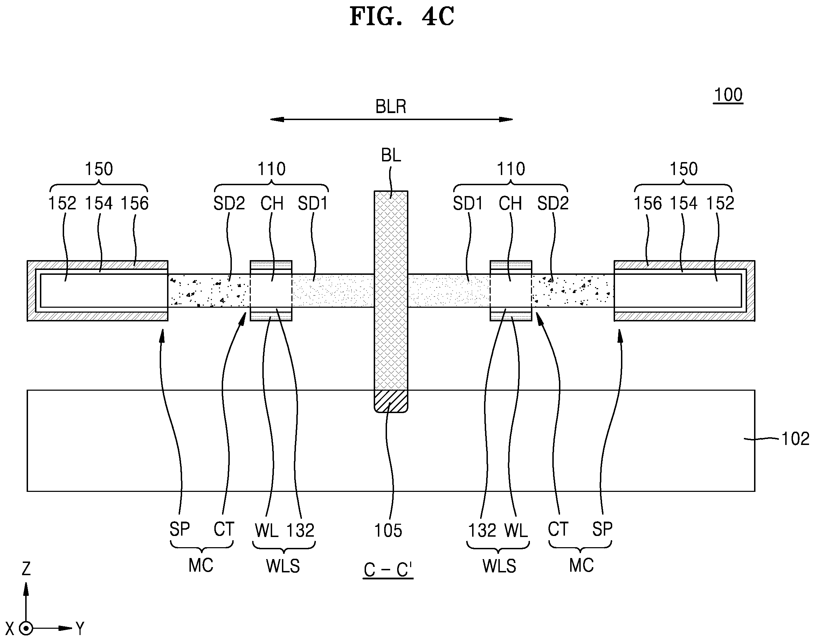

Referring to FIG. 1, a memory cell array of a semiconductor memory device 1 may include a plurality of sub-cell arrays SCA. Each of the sub-cell arrays SCA may include a plurality of bit lines BL, a plurality of word lines WL, and a plurality of memory cells MC. Each of the memory cells MC may include a cell transistor CT and an information storage element SP. One cell transistor CT may be arranged between one word line WL and one bit line BL. The information storage element SP may include a memory element that may store data. The information storage element SP may include a memory element using a capacitor, a memory element using a magnetic tunnel junction pattern, or a memory element using a variable resistor including a phase-change material. In some embodiments, the memory cells MC include random-access memory (RAM) cells. In some embodiments, the memory cells MC may include dynamic random-access memory (DRAM) cells and the information storage element SP may include a capacitor. A specific example thereof is described with reference to FIG. 4C below, but example embodiments are not limited thereto.

The word line WL may be spaced apart from a substrate and include a conductive pattern (e.g., a metal line) arranged above the substrate. The plurality of word lines WL may extend in a first horizontal direction (an X direction). The word lines WL of one sub-cell array SCA may be spaced apart from each other in a vertical direction (a Z direction). The bit line BL may extend from the substrate in the vertical direction (the Z direction). The bit lines BL of one sub-cell array SCA may be spaced apart from each other in the first horizontal direction (the X direction). The term "horizontal" may refer to a direction that runs parallel to an upper surface (e.g. a first, or main, surface) of the substrate. The term "vertical" may refer to a direction that runs perpendicular to the upper surface of the substrate. The upper surface of the substrate may be a surface on which the word lines WL are stacked. The vertical direction (the Z direction) may define a height direction. Various vertical levels may be defined along the vertical direction (the Z direction). The substrate may extend in the first horizontal direction (the X direction) and a second horizontal direction (a Y direction). The first horizontal direction (the X direction) and the second horizontal direction (a Y direction) may cross each other (e.g. may be perpendicular to each other). While the terms "horizontal" and "vertical" are used, it will be appreciated that these are relative to the structure of the semiconductor memory device 1 and need not limit the orientation of the semiconductor memory device 1 in use.

In a memory cell array of the semiconductor memory device 1, a plurality of word lines WL may extend in the first horizontal direction (the X direction) and may be spaced apart from one another in a second horizontal direction (a Y direction) and the vertical direction (the Z direction). In the memory cell array of the semiconductor memory device 1, a plurality of bit lines BL may extend in the vertical direction (the Z direction) and may be spaced apart from one another in the first horizontal direction (the X direction) and the second horizontal direction (the Y direction). The plurality of sub-cell arrays SCA may be arranged in the second horizontal direction (the Y direction). The second horizontal direction (the Y direction) may be perpendicular to the first horizontal direction (the X direction).

The gate of the cell transistor CT may be connected to a word line WL and the source region of the cell transistor CT may be connected to a bit line BL. The information storage element SP may be connected to the drain region of the cell transistor CT. In some embodiments, the information storage element SP may correspond to a capacitor, which includes a first electrode, a second electrode, and a capacitor dielectric film between the first electrode and the second electrode. The first electrode of the capacitor may be connected to the drain region of the cell transistor CT. The second electrode of the capacitor may be connected to a ground wire PP.

The memory cell array of the semiconductor memory device 1 may include a plurality of sub-cell arrays SCA that may be arranged in the second horizontal direction (the Y direction). Each of the sub-cell arrays SCA may include a plurality of memory cells MC, which are arranged in rows and columns and spaced apart from one another in the first horizontal direction (the X direction) and the vertical direction (the Z direction), a plurality of bit lines BL, which are connected to cell transistors CT of memory cells MC arranged in the vertical direction (the Z direction), extend in the vertical direction (the Z direction), are spaced apart from each other in the first horizontal direction (the X direction), and a plurality of word lines WL, which extend in the first horizontal direction (the X direction) and are spaced apart from each other in the vertical direction (the Z direction). The semiconductor memory device 1 may include a plurality of memory cell arrays.

The first horizontal direction (the X direction), the second horizontal direction (the Y direction), and the vertical direction (the Z direction) may be respectively referred to as a first direction, a second direction, and a third direction. Alternatively, the first horizontal direction (the X direction), the vertical direction (the Z direction), and the second horizontal direction (the Y direction) may be respectively referred to as a first direction, a second direction, and a third direction. The first direction, the second direction, and the third direction may be orthogonal to each other. It will be appreciated that the terms "first", "second", "third", etc. are labels intended to distinguish one entity from another, and need not imply any particular order (e.g. positioning, importance, etc.).

Two sub-cell arrays SCA adjacent to each other in the second horizontal direction (the Y direction) may share bit lines BL. The source regions of the cell transistors CT included in each of the two sub-cell arrays SCA may be connected to the bit lines BL shared by the two sub-cell arrays SCA. The source and drain regions of each cell transistor CT and the information storage element SP of one of the two sub-cell arrays SCA and the source and drain regions of each cell transistor CT and the information storage element SP of the other sub-cell array SCA may be arranged in opposite directions from each of the bit lines BL shared by the two sub-cell arrays SCA. For example, the source and drain regions of the cell transistor CT and the information storage element SP of one sub-cell array SCA connected to one bit line BL shared by two sub-cell arrays SCA may be sequentially arranged in the second horizontal direction (the Y direction), and the source and drain regions of the cell transistor CT and the information storage element SP of the other sub-cell array SCA may be arranged in an opposite direction to the second horizontal direction (the Y direction). For example, two memory cells MC at the same vertical level may be arranged between two adjacent bit lines BL in the second horizontal direction (the Y direction).

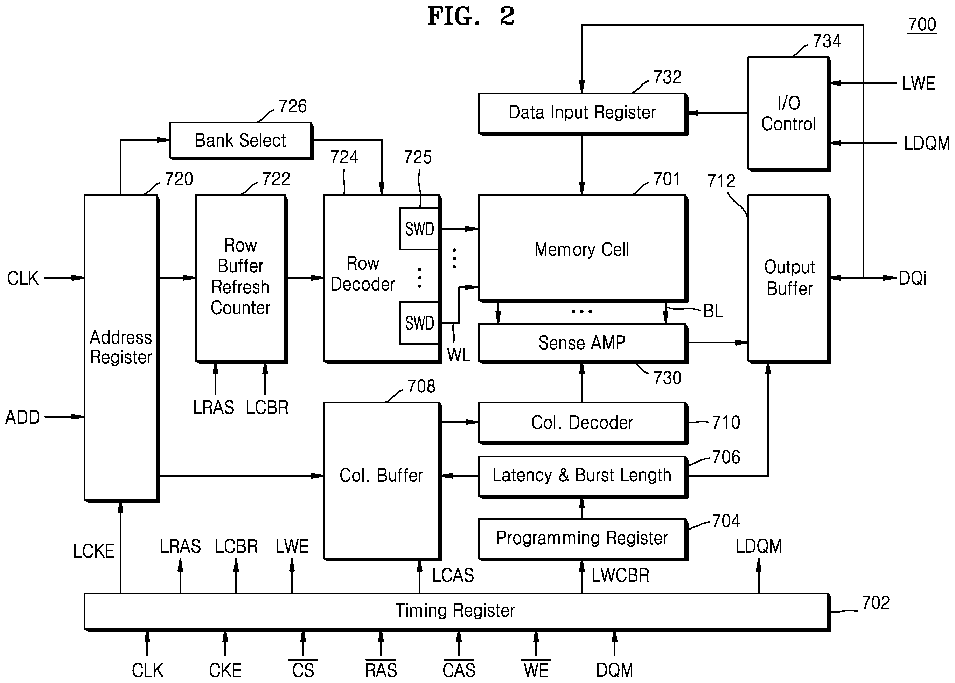

FIG. 2 is a block diagram illustrating a semiconductor memory device according to embodiments.

Referring to FIG. 2, a semiconductor memory device 700 may include a memory cell array 701, which includes a DRAM cell as a memory cell, and various kinds of circuit blocks driving the DRAM cell. For example, a timing register 702 may be activated when a chip select signal CSB changes from an inactive level (e.g., logic high) to an active level (e.g., logic low). The timing register 702 may receive command signals, such as a clock signal CLK, a clock enable signal CKE, the chip select signal CSB, a row address strobe signal RASB, a column address strobe signal CASB, a write enable signal WEB, and a data input/output (I/O) mask signal DQM, from the outside and may generate various internal command signals (e.g., LRAS, LCBR, LWE, LCAS, LWCBR, and LDQM) for controller circuit blocks by processing the received command signals.

Some internal command signals generated by the timing register 702 may be stored in a programming register 704. For example, latency information related to data output or burst length information may be stored in the programming register 704. The internal command signals stored in the programming register 704 may be provided to a latency/burst length controller 706. The latency/burst length controller 706 may provide a column decoder 710 or an output buffer 712 with a control signal for controlling a burst length or the latency of data output through a column address buffer 708.

An address register 720 may receive the clock signal CLK and an address signal ADD from the outside. A row address signal may be provided to a row decoder 724 through a row address buffer 722. A column address signal may be provided to the column decoder 710 through the column address buffer 708. The row address buffer 722 may further receive a refresh address signal, which is generated by a refresh counter in response to refresh commands (e.g., LRAS and LCBR) and may provide the row address signal or the refresh address signal to the row decoder 724. The address register 720 may provide a bank selector 726 with a bank signal for selecting a bank.

The row decoder 724 may decode the row address signal or the refresh address signal, each received from the row address buffer 722. The row decoder 724 may include a plurality of sub-word line drivers 725 (or sub-word line drivers SWD). Each of the sub-word line drivers 725 may activate a word line WL of the memory cell array 701. Each of the sub-word line drivers 725 may be connected to a word line WL of the memory cell array 701. The sub-word line drivers 725 may be adjacent to the memory cell array 701 and may be respectively formed as blocks spaced apart from each other by a certain distance in the row decoder 724. For example, the sub-word line drivers 725 may be perpendicular to a sense amplifier 730 and adjacent to an end of the memory cell array 701.

The column decoder 710 may decode a column address signal and perform a selection operation of a bit line BL of the memory cell array 701. For example, a column selection line may be applied to the semiconductor memory device 700, and the selection operation may be performed through the column selection line.

The sense amplifier 730 may be connected to bit lines BL of the memory cell array 701. The sense amplifier 730 may amplify data of a memory cell selected by the row decoder 724 and the column decoder 710 and provide the amplified data to the output buffer 712. Data DQi to be written to a data cell may be provided to the memory cell array 701 through a data input register 732, and an I/O controller 734 may control data transmission through the data input register 732.

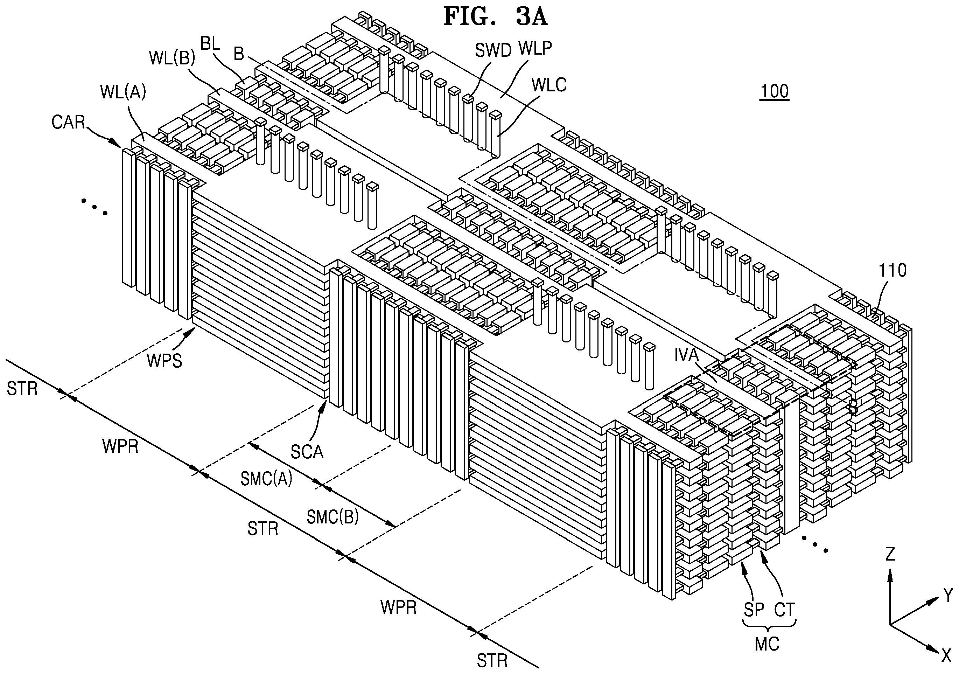

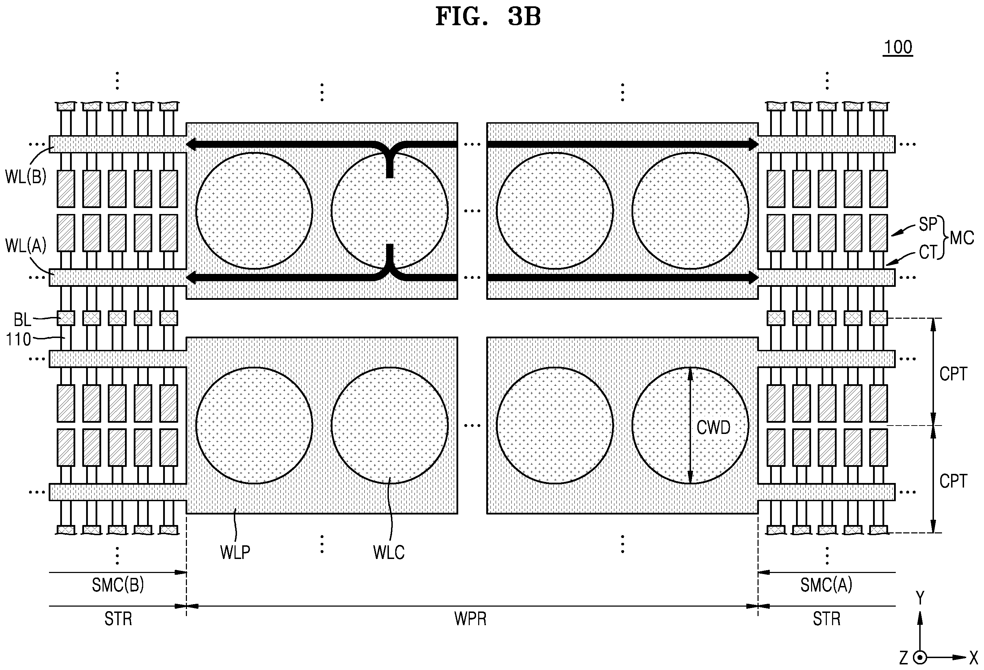

FIGS. 3A and 3B are respectively a perspective view and a plan view of a semiconductor memory device according to embodiments.

Referring to FIGS. 3A and 3B, a semiconductor memory device 100 may include a plurality of stack regions STR and a plurality of pad regions WPR. A stacked cell array structure CAR may be located in each of the stack regions STR. A pad structure WPS may be located in each of the pad regions WPR. The stack regions STR may be alternately arranged with the pad regions WPR in the first horizontal direction (the X direction). For example, a pad region WPR may be between two stack regions STR adjacent to each other in the first horizontal direction (the X direction), and a stack region STR may be between two pad regions WPR adjacent to each other in the first horizontal direction (the X direction).

The stacked cell array structure CAR may include a plurality of sub-cell arrays SCA. A plurality of sub-cell arrays SCA included in one stacked cell array structure CAR may be arranged in the second horizontal direction (the Y direction). A sub-cell array SCA may include a plurality of bit lines BL, a plurality of word lines WL, and a plurality of memory cells MC. Each of the memory cells MC may include a cell transistor CT and an information storage element SP. The cell transistor CT may include a semiconductor pattern 110. In some embodiments, the semiconductor pattern 110 may extend in the second horizontal direction (the Y direction). The semiconductor pattern 110 may include a source region and a drain region. The source region and the drain region may be respectively at opposite ends of the semiconductor pattern 110 in the second horizontal direction (the Y direction).

The word lines WL may extend in the first horizontal direction (the X direction). In the stacked cell array structure CAR, the word lines WL may extend in the first horizontal direction (the X direction) and may be spaced apart from one another in the second horizontal direction (the Y direction) and the vertical direction (the Z direction). Word lines WL in one sub-cell array SCA may be spaced apart from each other in the vertical direction (the Z direction). Two word lines that are at the same vertical level and adjacent to each other in the second horizontal direction (the Y direction) may be respectively referred to as a first word line WL(A) and a second word line WL(B).

A bit line BL may extend from a substrate in the vertical direction (the Z direction). In the stacked cell array structure CAR, a plurality of bit lines BL may extend in the vertical direction (the Z direction) and may be spaced apart from one another in the first horizontal direction (the X direction) and the second horizontal direction (the Y direction). Bit lines BL in one sub-cell array SCA may be spaced apart from each other in the first horizontal direction (the X direction). For example, the bit lines BL may include a bit line column of bit lines BL, which are spaced apart from each other in the first horizontal direction (the X direction). A plurality of bit line columns may be spaced apart from each other in the second horizontal direction (the Y direction). Each bit line column may be arranged along a line extending through the stack regions STR in the first horizontal direction (the X direction) between two word line pads WLP adjacent to each other in the second horizontal direction (the Y direction) at the same vertical level. In some embodiments, in a plan view, one bit line column and a pair of word lines WL may be repeatedly arranged in the second horizontal direction (the Y direction).

One cell transistor CT may be arranged between one word line WL and one bit line BL. The information storage element SP may be connected to the cell transistor CT. The information storage element SP may include a memory element that may store data. The gate of the cell transistor CT may be connected to the word line WL, and the source region of the cell transistor CT may be connected to the bit line BL. The information storage element SP may be connected to the drain region of the cell transistor CT. The cell transistor CT may be an n-type transistor (e.g. an n-type metal-oxide semiconductor (NMOS) transistor) or a p-type transistor (e.g. an p-type metal-oxide semiconductor (PMOS) transistor). In one embodiment, the cell transistor CT is an n-type transistor (e.g. an NMOS).

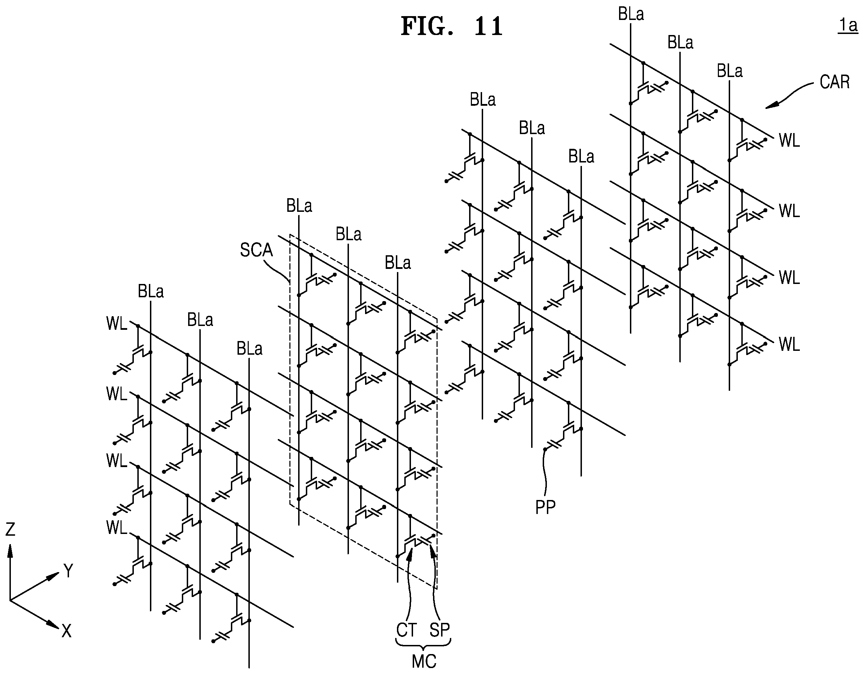

In some embodiments, the source region and the drain region of the cell transistor CT and the information storage element SP may be arranged in the second horizontal direction (the Y direction) from the bit line BL connected to the source region of the cell transistor CT. When two cell transistors CT are respectively connected to two bit lines BL adjacent to each other in the second horizontal direction (the Y direction), the source region and the drain region of one cell transistor CT and an information storage element SP connected to the cell transistor CT may be arranged in an opposite direction to a direction in which the source region and the drain region of the other cell transistor CT and an information storage element SP connected to the other cell transistor CT are arranged. For example, the source region and the drain region of a cell transistor CT connected to one of two bit lines BL adjacent to each other in the second horizontal direction (the Y direction) and an information storage element SP may be sequentially arranged in the second horizontal direction (the Y direction), and the source region and the drain region of a cell transistor CT connected to the other bit line BL and an information storage element SP may be arranged in the opposite direction to the second horizontal direction (the Y direction). For example, a plurality of bit lines BL may include a first bit line, a second bit line, a third bit line, and a fourth bit line, which are sequentially adjacent to each other in the second horizontal direction (the Y direction). For instance, the first bit line, the second bit line, the third bit line, and the fourth bit line may be arranged in a row along the second horizontal direction (the Y direction). A memory cell MC may not be arranged between the first bit line and a second bit line. Two memory cells MC may be arranged between the second bit line and the third bit line in the second horizontal direction (the Y direction) at the same vertical level. A memory cell MC may not be arranged between the third bit line and the fourth bit line (see, for instance, FIGS. 11-14).

The pad structure WPS in a pad region WPR may include a plurality of word line pads WLP spaced apart from each other in the vertical direction (the Z direction). One word line pad WLP may be connected to two word lines WL, e.g., a first word line WL(A) and a second word line WL(B), which are at the same vertical level and included in each of two stack regions STR respectively at opposite sides of the pad region WPR in the first horizontal direction (the X direction). For example, one word line pad WLP may be connected to two word lines WL including a first word line WL(A) and a second word line WL(B), which are at the same vertical level and arranged in one stack region STR adjacent to the word line pad WLP in the first horizontal direction (the X direction). For example, one word line pad WLP may be connected to four word lines WL including a first word line WL(A) and a second word line WL(B), which are at the same vertical level and arranged in a stack region STR at one side of the pad region WPR in the first horizontal direction (the X direction), and a first word line WL(A) and a second word line WL(B), which are at the same vertical level and arranged in another stack region STR at an opposite side of the pad region WPR.

In some embodiments, the width of the word line pad WLP in the second horizontal direction (the Y direction) may be greater than the distance between one side surface of the first word line WL(A) among both side surfaces thereof and one side surface of the second word line WL(B) among both side surfaces thereof in the second horizontal direction (the Y direction), wherein the first word line WL(A) and the second word line WL(B) are connected to the word line pad WLP and the one side surface of the first word line WL(A) is opposite to the one side surface of the second word line WL(B). The one side surface of the first word line WL(A) and the one side surface of the second word line WL(B) face away from each other. That is, the one side surface of the first word line WL(A) and the one side surface of the second word line WL(B) are outer side surfaces.

A pair of word lines WL may be arranged between two bit line columns adjacent to each other in the second horizontal direction (the Y direction) and may include a first word line WL(A) and a second word line WL(B), which are connected to one word line pad WLP. In a plan view, a bit line BL may not be arranged between a first word line WLn(A) and a second word line WLn(B), which are connected to one (e.g. the same) word line pad WLPn.

A word line contact WLC may be connected to the word line pad WLP. The word line contact WLC may be in contact with a word line pad WLP, which is electrically connected to the word line contact WLC, among word line pads WLP spaced apart from each other in the vertical direction (the Z direction) and may pass through a word line pad WLP above the word line pad WLP to which the word line contact WLC is in contact with. The word line contact WLC may not be electrically connected to a word line pad WLP through which the word line contact WLC passes because the word line contact WLC is not in contact with the word line pad WLP. For example, a contact insulating film may be between the word line contact WLC and the word line pad WLP through which the word line contact WLC passes. A word line contact WLC, which is connected to a topmost word line pad WLP among the word line pads WLP spaced apart from each other in the vertical direction (the Z direction), may not pass through a word line pad WLP. A word line contact WLC, which is connected to a bottommost word line pad WLP among the word line pads WLP spaced apart from each other in the vertical direction (the Z direction), may pass through all word line pads WLP except for the bottommost word line pad WLP.

A word line pad WLP may be connected to a sub-word line driver SWD through a word line contact WLC. The bottom end of the word line contact WLC may be in contact with the word line pad WLP. Although FIG. 3A illustrates the top end of the word line contact WLC is in contact with the sub-word line driver SWD, embodiments are not limited thereto. For example, a wire and/or a contact may be arranged between the top end of the word line contact WLC and the sub-word line driver SWD so that the word line contact WLC may be electrically connected to the sub-word line driver SWD.

The sub-word line driver SWD may activate a word line WL connected to a memory cell MC and thus select the memory cell MC together with a bit line BL. For example, the sub-word line driver SWD may activate the first word line WL(A) through the word line pad WLP and thus select a memory cell MC connected to the first word line WL(A) together with a bit line BL adjacent to the first word line WL(A) and may activate the second word line WL(B) through the word line pad WLP and thus select a memory cell MC connected to the second word line WL(B) together with a bit line BL adjacent to the second word line WL(B). Accordingly, the first word line WL(A) and the second word line WL(B), which are connected to one word line pad WLP, may share the word line pad WLP and the word line contact WLC and the sub-word line driver SWD, which are connected to the word line pad WLP.

Each of the word lines WL of the stacked cell array structure CAR in one stack region STR may be connected to a pair of word line pads WLP included in a pair of pad structures WPS in a pair of pad regions WPR adjacent to the stack region STR in the first horizontal direction (the X direction). A pad region WPR at one side of the stack region STR in the first horizontal direction (the X direction) may be referred to as a first pad region and a pad region WPR at an opposite side of the stack region STR in the first horizontal direction (the X direction) may be referred to as a second pad region. A stack region STR at one side of a pad region WPR in the first horizontal direction (the X direction) may be referred to as a first stack region and a stack region STR at an opposite side of the pad region WPR in the first horizontal direction (the X direction) may be referred to as a second stack region.

A plurality of memory cells MC may be divided into a first sub-memory cell group SMC(A) and a second sub-memory cell group SMC(B). The first sub-memory cell group SMC(A) may be adjacent to one pad structure WPS, which is located in the first pad region among a pair of pad structures WPS adjacent to the stack region STR, and the second sub-memory cell group SMC(B) may be adjacent to the other pad structure WPS, which is located in the second pad region among the pair of pad structures WPS adjacent to the stack region STR. Among the pair of pad structures WPS adjacent to the stack region STR, one pad structure WPS, which is adjacent to the first sub-memory cell group SMC(A) and located in the first pad region, may be referred to as a first pad structure and the other pad structure WPS, which is adjacent to the second sub-memory cell group SMC(B) and located in the second pad region, may be referred to as a second pad structure.

Each of memory cells MC in the first sub-memory cell group SMC(A) may be electrically connected through a word line WL to a sub-word line driver SWD connected to the first pad structure. Each of memory cells MC in the second sub-memory cell group SMC(B) may be electrically connected through a word line WL to a sub-word line driver SWD connected to the second pad structure. The sub-word line driver SWD connected to the first pad structure may be referred to as a first sub-word line driver and the sub-word line driver SWD connected to the second pad structure may be referred to as a second sub-word line driver.

The first sub-word line driver may activate a word line WL connected to a memory cell MC in the first sub-memory cell group SMC(A) and thus select the memory cell MC in the first sub-memory cell group SMC(A) together with a bit line BL. The second sub-word line driver may activate a word line WL connected to a memory cell MC in the second sub-memory cell group SMC(B) and thus select the memory cell MC in the second sub-memory cell group SMC(B) together with a bit line BL.

In some embodiments, the first sub-word line driver and the second sub-word line driver may together activate a word line WL connected to a memory cell MC, thereby selecting the memory cell MC together with a bit line BL. For example, a word line WL in the stack region STR between the first pad region and the second pad region may be connected to both a word line pad WLP in the first pad region and a word line pad WLP in the second pad region. The word line WL connected to the memory cell MC in the stack region STR between the first pad region and the second pad region may be activated by the first sub-word line driver connected to the word line pad WLP in the first pad region and the second sub-word line driver connected to the word line pad WLP in the second pad region. In other words, one memory cell MC may be selected by one sub-word line driver SWD among the first sub-word line driver and the second sub-word line driver or selected by two sub-word line drivers SWD including the first sub-word line driver and the second sub-word line driver.

The second sub-memory cell group SMC(B), which is adjacent to one pad region WPR and is located in the first stack region STR among a pair of stack regions STR respectively at opposite sides of the pad region WPR in the first horizontal direction (the X direction), and the first sub-memory cell group SMC(A), which is adjacent to the pad region WPR and is located in the second stack region STR, may be selected by sub-word line drivers SWD respectively connected to word line contacts WLC in the word line pad WLP.

A plurality of memory cells MC may be arranged at a cell pitch CPT in the second horizontal direction (the Y direction). For example, when two sub-cell arrays SCA adjacent to each other in the second horizontal direction (the Y direction) share a bit line BL, the cell pitch CPT may correspond to a length from between two information storage elements SP adjacent to each other in the second horizontal direction (the Y direction) (e.g. from a point equidistant between the two information storage elements SP) to the center of the bit lines BL in the second horizontal direction (the Y direction). In some embodiments, when two sub-cell arrays SCA adjacent to each other in the second horizontal direction (the Y direction) do not share a bit line BL, as shown in a semiconductor memory device 1a of FIG. 11, the cell pitch CPT may correspond to a length from between two information storage elements SP adjacent to each other in the second horizontal direction (the Y direction) (e.g. from a point equidistant between the two information storage elements SP) to between two bit lines BL adjacent to each other in the second horizontal direction (the Y direction) (e.g. to a point equidistant between the two bit lines BL).

A word line contact WLC may have a contact horizontal width CWD. In some embodiments, when the horizontal shape of the word line contact WLC is a circle, the contact horizontal width CWD may correspond to the diameter of the circle that is the horizontal shape of the word line contact WLC. In some embodiments, the contact horizontal width CWD may be greater than the cell pitch CPT.

In the semiconductor memory device 100 of inventive concepts, sub-word line drivers SWD respectively connected to word line contacts WLC in a pad region WPR between two stack regions STR adjacent to each other in the first horizontal direction (the X direction) may select memory cells MC respectively located in the two stack regions STR, and accordingly, the number of memory cells MC arranged in the first horizontal direction (the X direction) in one stack region STR may be increased. In other words, in the semiconductor memory device 100 of inventive concepts, memory cells MC in the first sub-memory cell group SMC(A) and memory cells MC in the second sub-memory cell group SMC(B) may form a single stacked cell array structure CAR, and memory cells MC respectively included in two stacked cell array structures CAR may be selected through one pad region WPR. Accordingly, an area occupied by the pad regions WPR in the semiconductor memory device 100 may be reduced. As a result, the integration density of the semiconductor memory device 100 may be increased.

In addition, in the semiconductor memory device 100 of inventive concepts, the first word line WL(A) and the second word line WL(B), which are connected to one word line pad WLP, may share the word line pad WLP and a word line contact WLC and a sub-word line driver SWD, which are connected to the word line pad WLP. Accordingly, the numbers of word line pads WLP and word line contacts WLC connected to each word line pad WLP may also be decreased in the semiconductor memory device 100, and therefore, the horizontal area of each word line pad WLP and each word line contact WLC may be increased. As a result, the word line contact WLC may be easily manufactured. Because the numbers of word line pads WLP and word line contacts WLC connected to each word line pad WLP may be decreased in the semiconductor memory device 100, the integration density of the semiconductor memory device 100 may be increased.

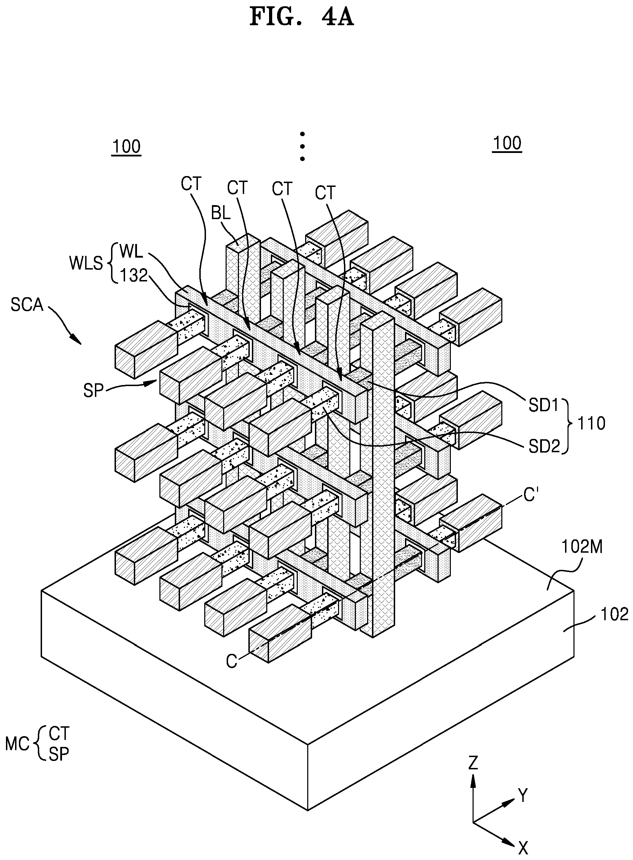

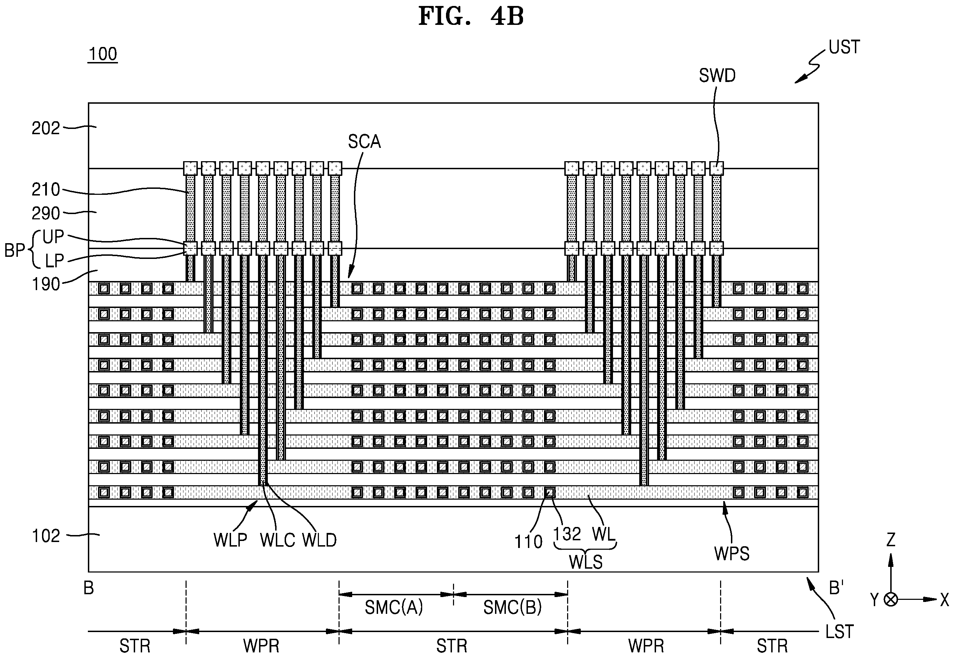

FIGS. 4A to 4C are a perspective view and cross-sectional views illustrating parts of a semiconductor memory device, according to embodiments. In detail, FIG. 4A is an enlarged perspective view of a region IVA in FIG. 3A. FIG. 4B is a cross-sectional view taken along line B-B' in FIG. 3A. FIG. 4C is a cross-sectional view taken along line C-C' in FIG. 4A.

Referring to FIGS. 4A to 4C, the semiconductor memory device 100 may include a lower structure LST and an upper structure UST stacked on the lower structure LST. The lower structure LST and the upper structure UST may be respectively referred to as a first structure and a second structure or a cell structure and a peripheral circuit structure.

The lower structure LST may have a plurality of stack regions STR and a plurality of pad regions WPR. The stack regions STR may be alternately arranged with the pad regions WPR in the first horizontal direction (the X direction). A pad region WPR at one side of the stack region STR in the first horizontal direction (the X direction) may be referred to as a first pad region and a pad region WPR at an opposite side of the stack region STR in the first horizontal direction (the X direction) may be referred to as a second pad region. The lower structure LST may include a substrate 102, a sub-cell array SCA on the substrate 102 in each stack region STR, and a pad structure WPS on the substrate 102 in each pad region WPR. A pad structure WPS in the first pad region may be referred to as a first pad structure and a pad structure WPS in the second pad region may be referred to as a second pad structure.

The semiconductor memory device 100 may include the substrate 102 and a plurality of sub-cell arrays SCA. The sub-cell arrays SCA may be arranged in the second horizontal direction (the Y direction). Each of the sub-cell arrays SCA may include the substrate 102, a plurality of word lines WL, which are separated from the substrate 102 and above a main surface 102M (otherwise known as an upper surface) of the substrate 102, a plurality of bit lines BL extending from the main surface 102M of the substrate 102 in the vertical direction (the Z direction), a plurality of cell transistors CT between the word lines WL and the bit lines BL, and a plurality of information storage elements SP connected to the cell transistors CT. A cell transistor CT and an information storage element SP may form a memory cell MC.

For example, the substrate 102 may include silicon (Si), such as crystalline Si, polycrystalline Si, or amorphous Si. For example, the substrate 102 may include a semiconductor element, such as germanium (Ge), or at least one compound semiconductor selected from silicon germanium (SiGe), silicon carbide (SiC), gallium arsenide (GaAs), indium arsenide (InAs), and indium phosphide (InP). The substrate 102 may include a silicon-on-insulator (SOI) substrate or a germanium-on-insulator (GeOI) substrate. For example, the substrate 102 may include a buried oxide (BOX) layer. The substrate 102 may include a conductive region, e.g., an impurity-doped well or an impurity-doped structure.

The word lines WL may be above the substrate 102, may extend in the first horizontal direction (the X direction) and may be spaced apart from each other in the vertical direction (the Z direction). The bit lines BL may extend from the substrate 102 in the vertical direction (the Z direction) and may be spaced apart from each other in the first horizontal direction (the X direction). Although it is illustrated in FIGS. 4A and 4B that the bit lines BL are spaced apart from each other in the first horizontal direction (the X direction) and extend in the vertical direction (the Z direction), the bit lines BL may be spaced apart from one another in the first horizontal direction (the X direction) and the second horizontal direction (the Y direction) and may extend in the vertical direction (the Z direction), as shown in FIGS. 1 and 3A.

One cell transistor CT may be between one word line WL and one bit line BL. The information storage element SP may be connected to the cell transistor CT. The cell transistor CT and the information storage element SP may be sequentially arranged in the second horizontal direction (the Y direction) from the bit line BL connected to the cell transistor CT. The cell transistor CT may be located between the information storage element SP and the bit line BL.

The word line WL may be adjacent to a semiconductor pattern 110. In some embodiments, the word line WL may surround the semiconductor pattern 110. A gate dielectric film 132 may be between the word line WL and the semiconductor pattern 110. The word line WL and the gate dielectric film 132 may form a word line structure WLS. The semiconductor pattern 110 and the word line structure WLS may form the cell transistor CT.

The semiconductor pattern 110 may include a source region SD1, a drain region SD2, and a channel region CH between the source region SD1 and the drain region SD2. The source region SD1 may be connected to the bit line BL and the drain region SD2 may be connected to the information storage element SP. The source region SD1 may be referred to as a direct contact and the drain region SD2 may be referred to as a buried contact.

The source region SD1, the channel region CH, and the drain region SD2 may be sequentially arranged from the bit line BL in the second horizontal direction (the Y direction) or in the opposite direction to the second horizontal direction (the Y direction). For example, two sub-cell arrays SCA adjacent to each other in the second horizontal direction (the Y direction) may share bit lines BL. Source regions SD1 of cell transistors CT included in each of the two sub-cell arrays SCA may be connected to the bit lines BL shared by the two sub-cell arrays SCA. The source region SD1, the channel region CH, and the drain region SD2 of a cell transistor CT and an information storage element SP, which are included in one of the two sub-cell arrays SCA, may be arranged from each of the bit lines BL, which are shared by the two sub-cell arrays SCA, in an opposite direction to a direction in which the source region SD1, the channel region CH, and the drain region SD2 of a cell transistor CT and an information storage element SP, which are included in the other sub-cell arrays SCA. For example, the source region SD1, the channel region CH, and the drain region SD2 of a cell transistor CT and an information storage element SP of one sub-cell array SCA connected to one bit line BL shared by two sub-cell arrays SCA may be sequentially arranged in the second horizontal direction (the Y direction), and the source region SD1, the channel region CH, and the drain region SD2 of a cell transistor CT and an information storage element SP of the other sub-cell array SCA may be arranged in the opposite direction to the second horizontal direction (the Y direction). For example, two memory cells MC may be arranged in the second horizontal direction (the Y direction) at the same vertical level between two bit lines BL sequentially adjacent to each other in the second horizontal direction (the Y direction) among the plurality of bit lines BL.

In some embodiments, the semiconductor pattern 110 may include a material having etching properties that are the same as or similar to those of the substrate 102 or may include the same material as the substrate 102. In some embodiments, the semiconductor pattern 110 may include Si. In some embodiments, the semiconductor pattern 110 may include a monocrystalline semiconductor material. For example, the semiconductor pattern 110 may include monocrystalline Si. In some embodiments, the semiconductor pattern 110 may include a two-dimensional (2D) semiconductor material or an oxide semiconductor material.

The semiconductor pattern 110 and the word line WL corresponding thereto may partially overlap each other in the vertical direction (the Z direction). In some embodiments, the semiconductor pattern 110 may extend in the second horizontal direction (the Y direction) through the word line WL. The channel region CH may include at least a portion of a part of the semiconductor pattern 110, which overlaps the word line WL in the vertical direction (the Z direction). In some embodiments, the channel region CH may include at least a portion of a part of the semiconductor pattern 110, which passes through the word line WL. For example, the channel region CH may correspond to a portion of the semiconductor pattern 110, which overlaps the word line WL in the vertical direction (the Z direction). In some embodiments, the channel region CH may correspond to a portion of the semiconductor pattern 110, which passes through the word line WL. The length of the channel region CH in the second horizontal direction (the Y direction) may be equal to the length (e.g. width) of the word line WL in the second horizontal direction (the Y direction). The length of the source region SD1 in the second horizontal direction (the Y direction) may be equal to the distance between the word line WL and the bit line BL in the second horizontal direction (the Y direction).

The source region SD1 and the drain region SD2 of the semiconductor pattern 110 may be doped with first impurities. In some embodiments, the channel region may be doped with second impurities different from the first impurities. For example, the first impurities may allow the source region SD1 and the drain region SD2 to have a first conductivity type, and the second impurities may allow the channel CH to have a second conductivity type different from the first conductivity type. In some embodiments, the first conductivity type may be n-type and the second conductivity type may be p-type, but embodiments are not limited thereto. For example, the first conductivity type may be p-type and the second conductivity type may be n-type, but embodiments are not limited thereto. When the first conductivity type is n-type, the first impurities may include phosphorus (P), arsenic (As), or antimony (Sb). When the second conductivity type is p-type, the second impurities may include boron (B), aluminum (Al), gallium (Ga), or indium (In). For example, the source region SD1 and the drain region SD2 of the semiconductor pattern 110 may be doped with phosphorus (P). While specific embodiments are described herein in which the source region SD1 connects to (e.g. contacts) the bit line BL and the drain region SD2 connects to (e.g. contacts) the memory cell MC, in alternative embodiments the locations of the source region SD1 and the drain region SD2 are swapped. That is, the source region SD1 may connect to (e.g. contact) the memory cell MC and the drain region SD2 may connect to (e.g. contact) the bit line BL.

The word line WL may surround a portion of the semiconductor pattern 110 with the gate dielectric film 132 between the word line WL and the portion of the semiconductor pattern 110. For example, the gate dielectric film 132 may cover the top and bottom surfaces of the portion of the semiconductor pattern 110 and opposite side surfaces of the portion of the semiconductor pattern 110 in the first horizontal direction (the X direction). The word line WL may cover the gate dielectric film 132, which covers the top and bottom surfaces and the opposite side surfaces in the first horizontal direction (the X direction) of the portion of the semiconductor pattern 110.

In some embodiments, the word line WL may include a conductive barrier film covering the gate dielectric film 132 and a conductive filling layer covering the conductive barrier film. For example, the conductive barrier film may include metal, conductive metal nitride, conductive metal silicide, or a combination thereof.

The gate dielectric film 132 may include at least one selected from the group consisting of silicon oxide, a high-k dielectric material (e.g. a material having a higher dielectric constant than silicon oxide), and a ferroelectric material. In some embodiments, the gate dielectric film 132 may have a stack structure of a first dielectric film including silicon oxide and a second dielectric film including at least one of a high-k dielectric material and a ferroelectric material.

The bit line BL may include metal. For example, the bit line BL may include, but not limited to, metal such as Ti, Ta, Mo, Ru, W, Co, Al, or Ni, conductive metal nitride such as TiN, TaN, WN, RuTiN, TiSiN, WSiN, or TaSiN, metal silicide such as TiSi, WSi, TaSi, CoSi, or NiSi, or a combination thereof.

An isolation insulating layer 105 may be between the substrate 102 and the bit line BL. The bit line BL may be on the isolation insulating layer 105. The semiconductor memory device 100 may include a plurality of isolation insulating layers 105 respectively corresponding to the plurality of bit lines BL. The isolation insulating layer 105 may electrically insulate the bit line BL from the substrate 102. At least a portion of the isolation insulating layer 105 may be embedded in the substrate 102. The isolation insulating layer 105 may be separated from the semiconductor pattern 110. In some embodiments, the isolation insulating layer 105 may include an insulating material including impurities. The impurities included in the isolation insulating layer 105 may be the same as the impurities included in the source region SD1 of the semiconductor pattern 110. For example, the isolation insulating layer 105 may include the first impurities. In some embodiments, the isolation insulating layer 105 may include phosphorus silicate glass (PSG) or boron silicate glass (BSG). For example, when the source region SD1 is of n-type as the first conductivity type, the isolation insulating layer 105 may include PSG. For example, when the source region SD1 is of p-type as the first conductivity type, the isolation insulating layer 105 may include BSG.

In some embodiments, the information storage element SP may correspond to a capacitor structure 150 including a first electrode 152, a second electrode 156, and a capacitor dielectric film 154 between the first electrode 152 and the second electrode 156. The capacitor structure 150 may include the first electrode 152 connected to the drain region SD2 and extending in the second horizontal direction (the Y direction), the capacitor dielectric film 154 covering the first electrode 152, and the second electrode 156 covering the capacitor dielectric film 154. The second electrode 156 may be connected to the ground wire PP in FIG. 1 or may be a part of the ground wire PP. The first electrode 152 and the second electrode 156 may be respectively referred to as a lower electrode and an upper electrode. The capacitor dielectric film 154 may be between the first electrode 152 and the second electrode 156.

The first electrode 152 may include metal, conductive metal nitride, conductive metal silicide, or a combination thereof. The capacitor dielectric film 154 may include at least one of a high-k dielectric material, which has a higher dielectric constant than silicon oxide, and a ferroelectric material. For example, the capacitor dielectric film 154 may include at least one of metal oxide and a dielectric material having a perovskite structure. For example, the second electrode 156 may include doped silicon, Ru, RuO, Pt, PtO, Ir, IrO, SRO (SrRuO), BSRO ((Ba,Sr)RuO), CRO (CaRuO), BaRuO, La(Sr,Co)O, Ti, TiN, W, WN, Ta, TaN, TiAlN, TiSiN, TaAlN, TaSiN, or a combination thereof. Although it is illustrated in FIGS. 3 to 4C that a plurality of information storage elements SP are separated from each other, embodiments are not limited thereto. In some embodiments, when a plurality of the information storage elements SP correspond to a plurality of capacitor structures 150, a plurality of second electrodes 156 of the capacitor structures 150 included in a sub-cell array SCA may be connected to each other to integrally form a single body. In some embodiments, when a plurality of the information storage elements SP correspond to a plurality of capacitor structures 150 and when a plurality of capacitor structures 150 respectively included in two sub-cell arrays SCA adjacent to each other in the second horizontal direction (the Y direction) face and are adjacent to each other, respective second electrodes 156 of the capacitor structures 150 respectively included in the two sub-cell arrays SCA may be connected to each other to integrally form a single body.

A pad structure WPS in a pad region WPR may include a plurality of word line pads WLP spaced apart from each other in the vertical direction (the Z direction). One word line pad WLP may be connected to a word line WL, which is at the same vertical level as the word line pad WLP and is included in each of two stack regions STR respectively at opposite sides of the pad region WPR in the first horizontal direction (the X direction). In some embodiments, the word line pad WLP and the word line WL connected thereto may be integrally formed. A word line contact WLC may be connected to the word line pad WLP. The word line contact WLC may include metal, conductive metal nitride, conductive metal silicide, or a combination thereof. A first bonding pad LP may be connected to the top of the word line contact WLC.

A first insulating structure 190 may cover a sub cell array SCA and a pad structure WPS on the substrate 102. The first insulating structure 190 may surround a plurality of word lines WL, a plurality of word line contacts WLC, and a plurality of first bonding pads LP. The top surfaces of the first bonding pads LP may be coplanar with the top surface of the first insulating structure 190.

In embodiments, the first insulating structure 190 may include an insulating material which may include silicon oxide, silicon nitride, a low-k dielectric material, or a combination thereof. The low-k dielectric material may have a lower dielectric constant than silicon oxide and may include, for example, PSG, borophosphosilicate glass (BPSG), fluorosilicate glass (FSG), organosilicate glass (OSG), spin-on-glass (SOG), spin-on-polymer, or a combination thereof. In some embodiments, the first insulating structure 190 may include an ultra-low k (ULK) film. The ULK film may have an ultra-low dielectric constant K of about 2.2 to 2.4. The ULK film may include SiOC or SiCOH. The first bonding pads LP may include a conductive material which may include copper (Cu), gold (Au), silver (Ag), aluminum (Al), tungsten (W), titanium (Ti), tantalum (Ta), or a combination thereof.

The upper structure UST may include a peripheral circuit substrate 202, a second insulating structure 290 covering the bottom surface of the peripheral circuit substrate 202, a plurality of sub-word line drivers SWD between the peripheral circuit substrate 202 and the second insulating structure 290, a plurality of interconnect structures 210 respectively connected to the sub-word line drivers SWD, and a plurality of second bonding pads UP respectively connected to the bottom ends of the interconnect structures 210. The second insulating structure 290 may surround the interconnect structures 210 and the second bonding pads UP. The bottom surfaces of the second bonding pads UP may be coplanar with the bottom surface of the second insulating structure 290. The interconnect structures 210 may electrically connect the sub-word line drivers SWD to the second bonding pads UP. The peripheral circuit substrate 202 may include a material that is the same as or similar to that of the substrate 102. The second bonding pads UP may include a material that is the same as or similar to that of the first bonding pads LP. The second insulating structure 290 may include a material that is the same as or similar to that of the first insulating structure 190. Although FIG. 4B shows each of the interconnect structures 210 has only a contact, this is just an example and inventive concepts are not limited thereto. For example, each of the interconnect structures 210 may be include at least one wiring layer and at least one contact.

The second insulating structure 290 may be in contact with the first insulating structure 190 and the second bonding pads UP may be in contact with the first bonding pads LP, respectively, and thus, the upper structure UST may be bonded to the lower structure LST. In some embodiments, the lower structure LST and the upper structure UST may be bonded to each other by a metal-oxide hybrid bonding method, and accordingly, the word lines WL of the lower structure LST may be electrically connected to the sub-word line drivers SWD of the upper structure UST. For example, the first bonding pads LP and the second bonding pads UP respectively corresponding to the first bonding pads LP may be expanded by heat to come into contact with each other and may then undergo diffusion bonding, in which metal atoms of the first bonding pads LP are integrated with metal atoms of the second bonding pads UP through diffusion, thereby forming a plurality of bonding pads BP. For example, the first insulating structure 190 may be covalently bonded to the second insulating structure 290. A portion of each of the bonding pads BP, which is surrounded by the first insulating structure 190, may correspond to a first bonding pad LP and the other portion of each of the bonding pads BP, which is surrounded by the second insulating structure 290, may correspond to a second bonding pad UP.

One word line WL may be connected to a pair of word line pads WLP corresponding to a pair of pad regions WPR adjacent to the word line WL. A word line contact WLC may be connected to a word line pad WLP. The word line contact WLC may be in contact with a word line WL electrically connected thereto among word lines WL spaced apart from each other in the vertical direction (the Z direction) and may pass through a word line WL above the word line WL electrically connected thereto. The word line contact WLC may not be in contact with the word line WL, through which the word line contact WLC passes, and thus not be electrically connected to the word line WL. For instance, the word line contact WLC may pass through any word line WL above the word line WL to which it is electrically connected. The word line contact WLC may not be in contact with any of the word lines WL through which the word line contact WLC passes, and thus may not be electrically connected to those word lines WL. For example, a contact insulating film WLD may be between the word line contact WLC and the word line(s) WL through which the word line contact WLC passes. The word line contact WLC connected to a topmost word line WL among the word lines WL spaced apart from each other in the vertical direction (the Z direction) may not pass through any word line WL. The word line contact WLC connected to a bottommost word line WL among the word lines WL spaced apart from each other in the vertical direction (the Z direction) may pass through all word lines WL except for the bottommost word line WL.

In some embodiments, one word line contact WLC in one pad region WPR may be connected to each of the word lines WL of one sub-cell array SCA, but inventive concepts are not limited thereto. For example, the number of word line contacts WLC, which are connected to each of the word lines WL of one sub-cell array SCA, in one pad region WPR may be an integer of at least 1 (e.g. greater than or equal to 1). When one word line contact WLC in one pad region WPR is connected to each of the word lines WL of one sub-cell array SCA, the lengths of word line contacts WLC in the pad region WPR in the vertical direction (the Z direction) may be different. Among the word line contacts WLC in the pad region WPR, a word line contact WLC relatively far from a pair of stack regions STR adjacent to the pad region WPR in the first horizontal direction (the X direction) may be longer in the vertical direction (the Z direction) than a word line contact WLC relatively closer to the pair of stack regions STR. For example, in an X-Z plane, the bottom ends of the word line contacts WLC in the pad region WPR may be arranged along a V-shape. For instance, a central word line contact WLC among the word line contacts WLC in a pad region WPR may be the longest (in the vertical direction (the Z direction)), and the lengths of the word line contacts WLC may get progressively shorter towards the edges of the pad region WPR (in the first horizontal direction (the X direction)) (e.g. as they approach the neighboring stack regions STR).

A word line pad WLP may be connected to a sub-word line driver SWD through a word line contact WLC. The bottom end of the word line contact WLC may be in contact with the word line pad WLP. A word line WL may be connected to a plurality of sub-word line drivers SWD through word line contacts WLC respectively connected to a plurality of word line pads WLP, bonding pads BP, and interconnect structures 210.

A plurality of memory cells MC may be divided into a first sub-memory cell group SMC(A) and a second sub-memory cell group SMC(B). The first sub-memory cell group SMC(A) may be adjacent to one pad structure WPS, which is located in the first pad region among a pair of pad structures WPS adjacent to the stack region STR, and the second sub-memory cell group SMC(B) may be adjacent to the other pad structure WPS, which is located in the second pad region among the pair of pad structures WPS adjacent to the stack region STR. Each of memory cells MC in the first sub-memory cell group SMC(A) may be electrically connected through a word line WL to a sub-word line driver SWD connected to the first pad structure. Each of memory cells MC in the second sub-memory cell group SMC(B) may be electrically connected through a word line WL to a sub-word line driver SWD connected to the second pad structure. The first sub-word line driver may activate a word line WL connected to a memory cell MC in the first sub-memory cell group SMC(A) and thus select the memory cell MC in the first sub-memory cell group SMC(A) together with a bit line BL. The second sub-word line driver may activate a word line WL connected to a memory cell MC in the second sub-memory cell group SMC(B) and thus select the memory cell MC in the second sub-memory cell group SMC(B) together with a bit line BL.

The second sub-memory cell group SMC(B), which is adjacent to one pad region WPR and is located in one stack region STR among a pair of stack regions STR respectively at opposite sides of the pad region WPR in the first horizontal direction (the X direction), and the first sub-memory cell group SMC(A), which is adjacent to the pad region WPR and is located in the other stack region STR, may be selected by sub-word line drivers SWD respectively connected to word line contacts WLC in the word line pad WLP.

In the semiconductor memory device 100, according to some embodiments of inventive concepts, sub-word line drivers SWD respectively connected to word line contacts WLC in a pad region WPR between two stack regions STR adjacent to each other in the first horizontal direction (the X direction) may select memory cells MC respectively located in the two stack regions STR, and accordingly, the number of memory cells MC arranged in the first horizontal direction (the X direction) in one stack region STR may be increased and an area occupied by the pad regions WPR in the semiconductor memory device 100 may be reduced. Accordingly, the integration density of the semiconductor memory device 100 may be increased.

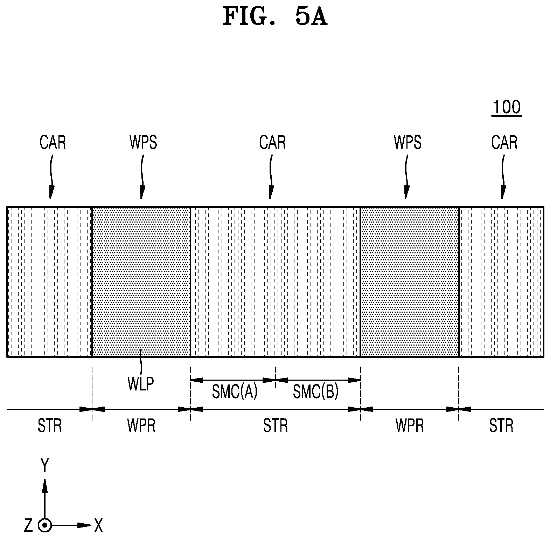

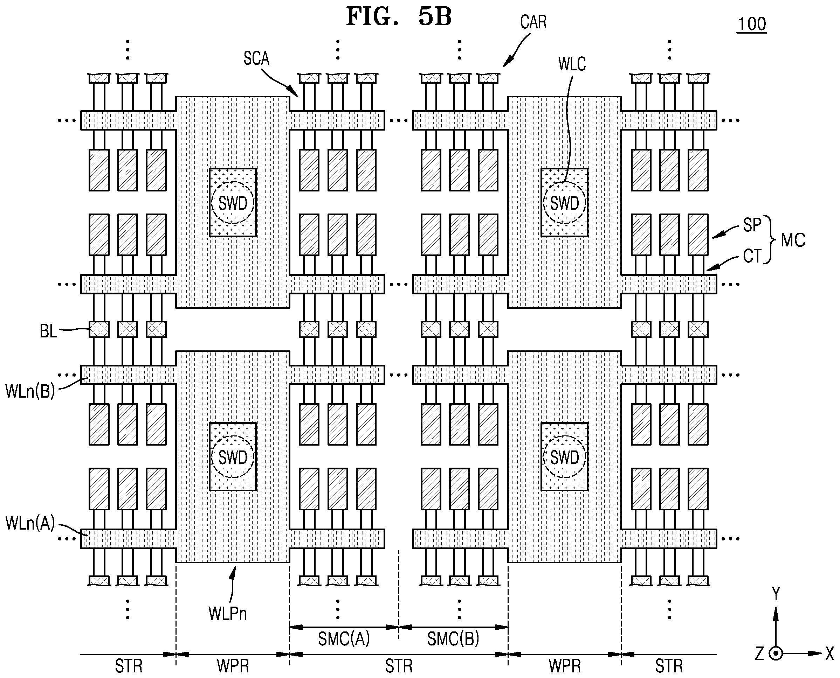

FIG. 5A is a plan view illustrating the semiconductor memory device 100 according to embodiments, and FIG. 5B is a plan view illustrating a part of the semiconductor memory device 100 according to embodiments.

Referring to FIG. 5A, the semiconductor memory device 100 may have a plurality of stack regions STR and a plurality of pad regions WPR. A stacked cell array structure CAR may be in each of the stack regions STR, and a pad structure WPS including a word line pad WLP may be in each of the pad regions WPR. The stack regions STR may be alternately arranged with the pad regions WPR in the first horizontal direction (the X direction). The stack regions STR may be spaced apart from each other in the first horizontal direction (the X direction) and the pad regions WPR may be spaced apart from each other in the first horizontal direction (the X direction). For example, a pad region WPR may be between two stack regions STR adjacent to each other in the first horizontal direction (the X direction), and a stack region STR may be between two pad regions WPR adjacent to each other in the first horizontal direction (the X direction).

The stacked cell array structure CAR may include a first sub-memory cell group SMC(A) and a second sub-memory cell group SMC(B). The first sub-memory cell group SMC(A) may be adjacent to one pad region WPR among a pair of pad regions WPR adjacent to the stack region STR in the first horizontal direction (the X direction), and the second sub-memory cell group SMC(B) may be adjacent to the other pad region WPR among the pair of pad regions WPR adjacent to the stack region STR in the first horizontal direction (the X direction). The first sub-memory cell group SMC(A) may be connected to the pad structure WPS in the one pad region WPR, and the second sub-memory cell group SMC(B) may be connected to the pad structure WPS in the other pad region WPR.

Because the plurality of stack regions STR are alternately arranged with the plurality of pad regions WPR in the first horizontal direction (the X direction) in the semiconductor memory device 100, the horizontal width of the stack regions STR in the first horizontal direction (the X direction) may be increased and the horizontal width of the pad regions WPR in the first horizontal direction (the X direction) may be decreased. Accordingly, the integration density of the semiconductor memory device 100 may be increased.

Referring to FIG. 5B, the semiconductor memory device 100 may have a plurality of stack regions STR and a plurality of pad regions WPR. A stacked cell array structure CAR may be in each of the stack regions STR and a pad structure WPS may be in each of the pad regions WPR. The stacked cell array structure CAR may include a plurality of sub-cell arrays SCA. The stack regions STR may be alternately arranged with the pad regions WPR in the first horizontal direction (the X direction). The stacked cell array structure CAR may include a first sub-memory cell group SMC(A), which is adjacent to one pad region WPR among a pair of pad regions WPR adjacent to a stack region STR, and a second sub-memory cell group SMC(B), which is adjacent to the other pad region WPR.

Each of the sub-cell arrays SCA may include a plurality of word lines WL, a plurality of bit lines BL, and a plurality of memory cells MC between the word lines WL and the bit lines BL. Each of the memory cells MC may include a cell transistor CT and an information storage element SP.

The word lines WL may extend in the first horizontal direction (the X direction) and may be spaced apart from each other in the vertical direction (the Z direction). The pad structure WPS in each of the pad regions WPR may include a plurality of word line pads WLP spaced apart from each other in the vertical direction (the Z direction). FIG. 5B illustrates n-th word lines WLn and n-th word line pads WLPn when "n" word lines WL are spaced apart from each other in the vertical direction (the Z direction) and "n" word line pads WLP are spaced apart from each other in the vertical direction (the Z direction). "n" may be an integer greater than or equal to one. One n-th word line pad WLPn may be connected to two n-th word lines WLn, e.g., a first word line WLn(A) and a second word line WLn(B), which are at the same vertical level and included in each of a pair of stack regions STR respectively at opposite sides a pad region WPR in the first horizontal direction (the X direction). For example, the n-th word line pad WLPn may be connected to two n-th word lines WLn including the first word line WLn(A) and the second word line WLn(B), which are at the same vertical level and included in one stack region STR adjacent to the pad region WPR in the first horizontal direction (the X direction). For example, the n-th word line pad WLPn may be connected to four n-th word lines WLn including the first word line WLn(A) and the second word line WLn(B), which are at the same vertical level and included in a stack region STR at one side of the pad region WPR in the first horizontal direction (the X direction), and the first word line WLn(A) and the second word line WLn(B), which are at the same vertical level and included in another stack region STR at an opposite side of the pad region WPR in the first horizontal direction (the X direction).

Memory cells MC included in a first sub-memory cell group SMC(A) may be selected by sub-word line drivers SWD, which are connected to n-th word lines WLn through one pad region WPR adjacent to the first sub-memory cell group SMC(A) in the first horizontal direction (the X direction). Memory cells MC included in a second sub-memory cell group SMC(B) may be selected by sub-word line drivers SWD, which are connected to n-th word lines WLn through another pad region WPR adjacent to the second sub-memory cell group SMC(B) in the first horizontal direction (the X direction). For example, one sub-word line driver SWD may select a memory cell MC, which is connected to a bit line BL selected from a plurality of bit lines BL, among memory cells MC included in the first sub-memory cell group SMC(A) and connected to a first word line WLn(A), memory cells MC included in the first sub-memory cell group SMC(A) and connected to a second word line WLn(B), memory cells MC included in the second sub-memory cell group SMC(B) and connected to a first word line WLn(A), and memory cells MC included in the second sub-memory cell group SMC(A) and connected to a second word line WLn(B).

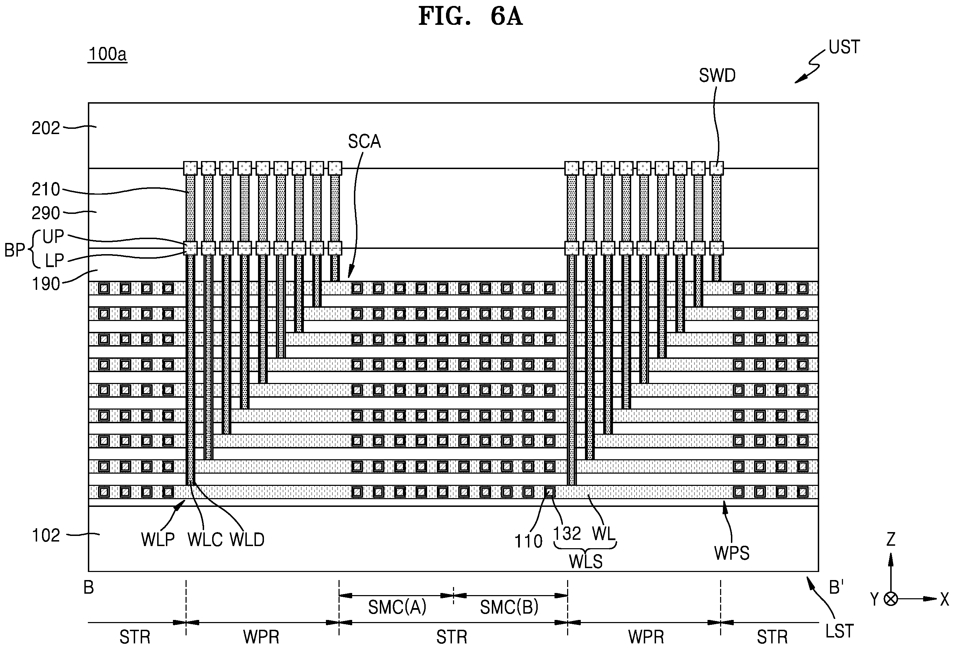

FIGS. 6A to 6C are cross-sectional views each illustrating a part of a semiconductor memory device according to embodiments. In detail, FIGS. 6A to 6C are cross-sectional views taken along line B-B' in FIG. 3A. For brevity, repeated features from earlier embodiments may not be described, and the description will therefore focus on differences relative to the earlier embodiments.

Referring to FIG. 6A, a semiconductor memory device 100a may include a lower structure LST and an upper structure UST stacked on the lower structure LST. The lower structure LST may have a plurality of stack regions STR and a plurality of pad regions WPR. The lower structure LST may include a substrate 102, a sub-cell array SCA on the substrate 102 in each stack region STR, and a pad structure WPS on the substrate 102 in each pad region WPR. The sub-cell array SCA may include the substrate 102, a plurality of word lines WL, which are above and separated from the substrate 102, a plurality of bit lines BL extending from the substrate 102 in the vertical direction (the Z direction), a plurality of cell transistors CT between the word lines WL and the bit lines BL, and a plurality of information storage elements SP connected to the cell transistors CT. A cell transistor and an information storage element SP may form a memory cell MC.

Each of the word lines WL may be connected to at least one word line pad WLP. A word line contact WLC may be connected to the word line pad WLP.

When each of the word lines WL of one sub-cell array SCA is connected to one word line contact WLC in one pad region WPR, word line contacts WLC in the pad region WPR may have different lengths in the vertical direction (the Z direction). The lengths of the word line contacts WLC in the pad region WPR in the vertical direction (the Z direction) may sequentially decrease in the first horizontal direction (the X direction). For example, in an X-Z plane, the bottom ends of the word line contacts WLC in one pad region WPR may be arranged in a diagonal direction with respect to the first horizontal direction (the X direction) and the vertical direction (the Z direction).

The bottom ends of the word line contacts WLC in one pad region WPR among a pair of pad regions WPR respectively at opposite sides of one stack region STR in the first horizontal direction (the X direction) and the bottom ends of the word line contacts WLC in the other pad region WPR may be arranged in the same diagonal direction with respect to the first horizontal direction (the X direction) and the vertical direction (the Z direction).

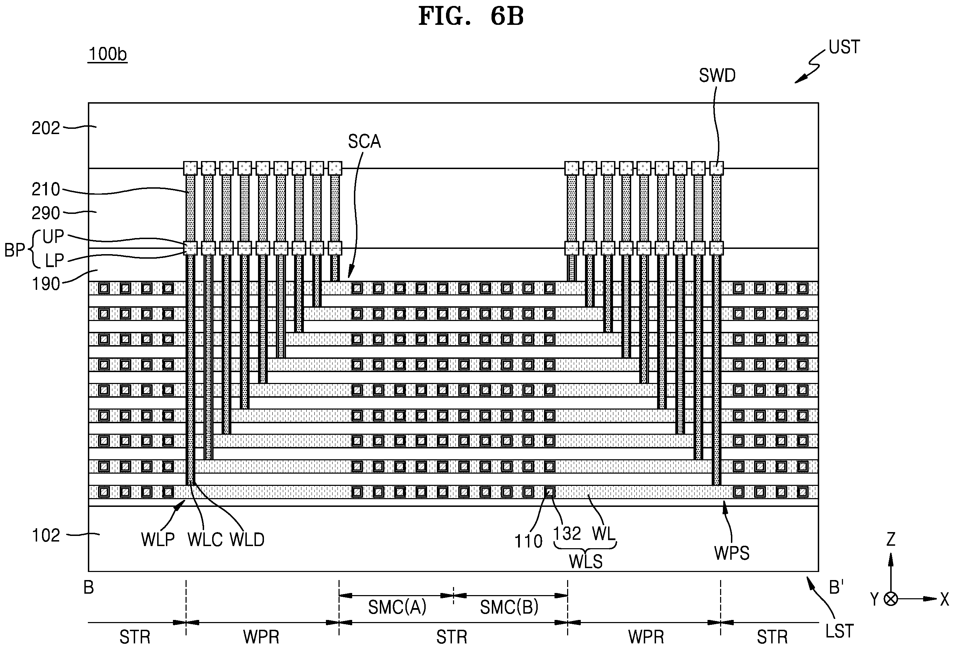

Referring to FIG. 6B, a semiconductor memory device 100b may include a lower structure LST and an upper structure UST stacked on the lower structure LST. The lower structure LST may have a plurality of stack regions STR and a plurality of pad regions WPR. The lower structure LST may include a substrate 102, a sub-cell array SCA on the substrate 102 in each stack region STR, and a pad structure WPS on the substrate 102 in each pad region WPR. The sub-cell array SCA may include the substrate 102, a plurality of word lines WL, which are above and separated from the substrate 102, a plurality of bit lines BL extending from the substrate 102 in the vertical direction (the Z direction), a plurality of cell transistors CT between the word lines WL and the bit lines BL, and a plurality of information storage elements SP connected to the cell transistors CT. A cell transistor and an information storage element SP may form a memory cell MC.

Each of the word lines WL may be connected to at least one word line pad WLP. A word line contact WLC may be connected to the word line pad WLP.

When each of the word lines WL of one sub-cell array SCA is connected to one word line contact WLC in one pad region WPR, word line contacts WLC in the pad region WPR may have different lengths in the vertical direction (the Z direction). The lengths of the word line contacts WLC in the pad region WPR in the vertical direction (the Z direction) may sequentially decrease in the first horizontal direction (the X direction). For example, in an X-Z plane, the bottom ends of the word line contacts WLC in one pad region WPR may be arranged in a diagonal direction with respect to the first horizontal direction (the X direction) and the vertical direction (the Z direction).

The bottom ends of the word line contacts WLC in one pad region WPR among a pair of pad regions WPR respectively at opposite sides of one stack region STR in the first horizontal direction (the X direction) and the bottom ends of the word line contacts WLC in the other pad region WPR may be arranged in mirror symmetry with respect to the stack region STR. For instance, the length of the word line contacts WLC in each of a pair of pad regions WPR on opposite sides of a stack region may decrease as the word line contacts WLC get closer to the stack region STR that is between the pair of pad regions WPR. Alternatively, the length of the word line contacts WLC in each of a pair of pad regions WPR on opposite sides of a stack region may increase as the word line contacts WLC get closer to the stack region STR that is between the pair of pad regions WPR.

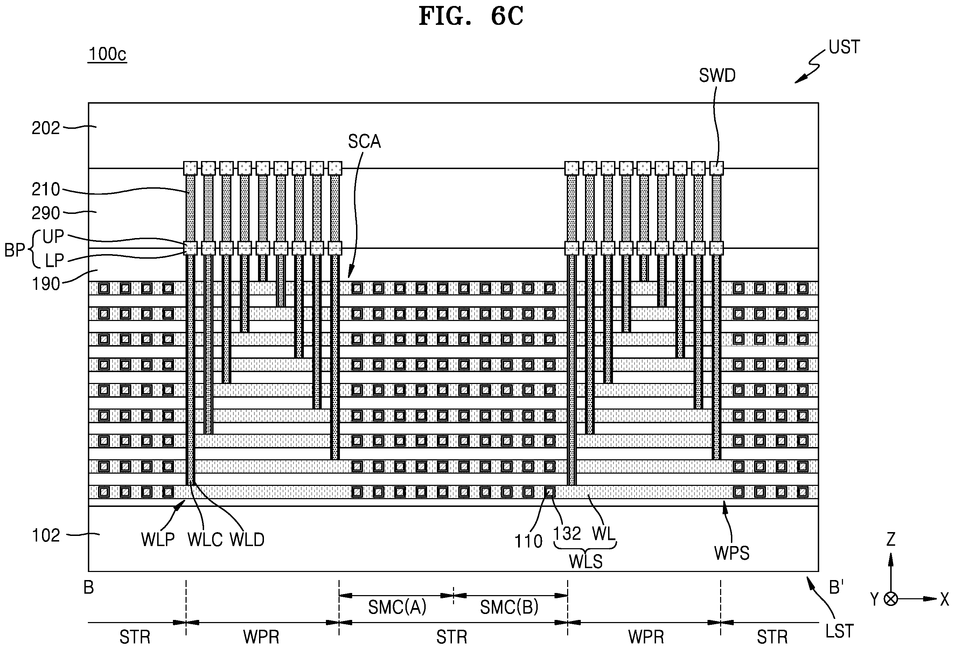

Referring to FIG. 6C, a semiconductor memory device 100c may include a lower structure LST and an upper structure UST stacked on the lower structure LST. The lower structure LST may have a plurality of stack regions STR and a plurality of pad regions WPR. The lower structure LST may include a substrate 102, a sub-cell array SCA on the substrate 102 in each stack region STR, and a pad structure WPS on the substrate 102 in each pad region WPR. The sub-cell array SCA may include the substrate 102, a plurality of word lines WL, which are above and separated from the substrate 102, a plurality of bit lines BL extending from the substrate 102 in the vertical direction (the Z direction), a plurality of cell transistors CT between the word lines WL and the bit lines BL, and a plurality of information storage elements SP connected to the cell transistors CT. A cell transistor and an information storage element SP may form a memory cell MC.

Each of the word lines WL may be connected to at least one word line pad WLP. A word line contact WLC may be connected to the word line pad WLP.

When each of the word lines WL of one sub-cell array SCA is connected to one word line contact WLC in one pad region WPR, word line contacts WLC in the pad region WPR may have different lengths in the vertical direction (the Z direction). Among word line contacts WLC in one pad region WPR, a word line contact WLC relatively far from a pair of stack regions STR adjacent to the pad region WPR in the first horizontal direction (the X direction) may be shorter in the vertical direction (the Z direction) than a word line contact WLC relatively closer to the pair of stack regions STR. For example, in an X-Z plane, the bottom ends of the word line contacts WLC in the pad region WPR may be arranged in an upside-down V-shape. For instance, a central word line contact WLC among the word line contacts WLC in a pad region WPR may be the shortest (in the vertical direction (the Z direction)), and the lengths of the word line contacts WLC may get progressively longer towards the edges of the pad region WPR (in the first horizontal direction (the X direction)) (e.g. as they approach the neighboring stack regions STR).

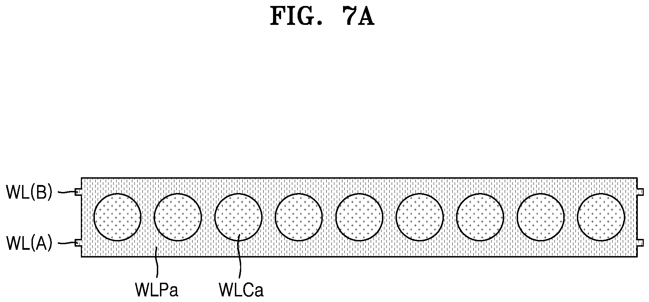

FIGS. 7A to 7E are plan views each illustrating a word line pad and word line contacts of a semiconductor memory device, according to embodiments.

Referring to FIG. 7A, a first word line WL(A) and a second word line WL(B) may be connected to each of opposite ends of a word line pad WLPa. In a plan view, a plurality of word line contacts WLCa may be arranged in the word line pad WLPa. The word line contacts WLCa may be arranged in a line and spaced apart from each other in one direction between the opposite ends of the word line pad WLPa.

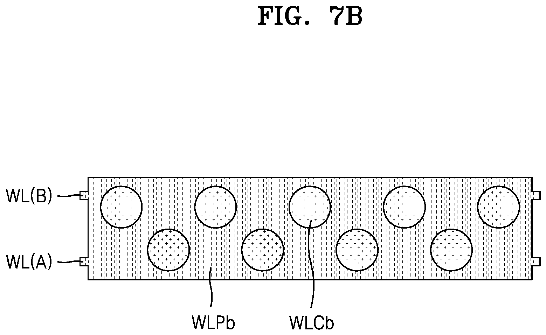

Referring to FIG. 7B, a first word line WL(A) and a second word line WL(B) may be connected to each of opposite ends of a word line pad WLPb. In a plan view, a plurality of word line contacts WLCb may be arranged in the word line pad WLPb. The word line contacts WLCb may be arranged in zigzag and spaced apart from each other between the opposite ends of the word line pad WLPa.

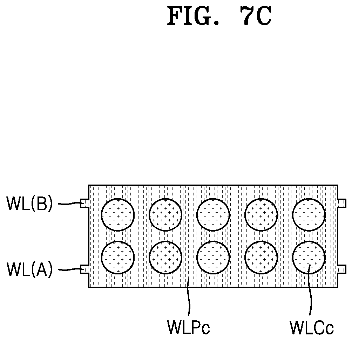

Referring to FIG. 7C, a first word line WL(A) and a second word line WL(B) may be connected to each of opposite ends of a word line pad WLPc. In a plan view, a plurality of word line contacts WLCc may be arranged in the word line pad WLPc. The word line contacts WLCc may be arranged in two or more rows and spaced apart from each other in one direction between the opposite ends of the word line pad WLPc.

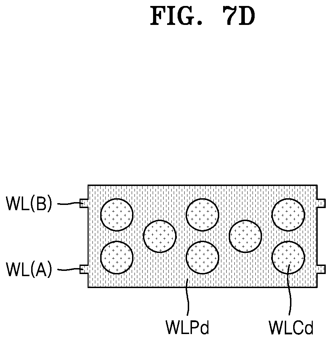

Referring to FIG. 7D, a first word line WL(A) and a second word line WL(B) may be connected to each of opposite ends of a word line pad WLPd. In a plan view, a plurality of word line contacts WLCd may be arranged in the word line pad WLPd. The word line contacts WLCd may be arranged to zigzag in a first horizontal direction or a second horizontal direction, forming a honeycomb pattern, between the opposite ends of the word line pad WLPd, wherein the first horizontal direction and the second horizontal direction are perpendicular to each other.

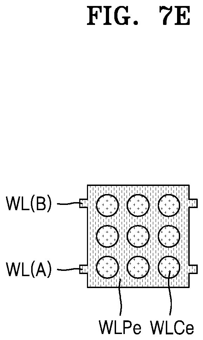

Referring to FIG. 7E, a first word line WL(A) and a second word line WL(B) may be connected to each of opposite ends of a word line pad WLPe. In a plan view, a plurality of word line contacts WLCe may be arranged in the word line pad WLPe. The word line contacts WLCe may be arranged in lines in a first horizontal direction or a second horizontal direction, forming a matrix pattern, between the opposite ends of the word line pad WLPe, wherein the first horizontal direction and the second horizontal direction are perpendicular to each other.

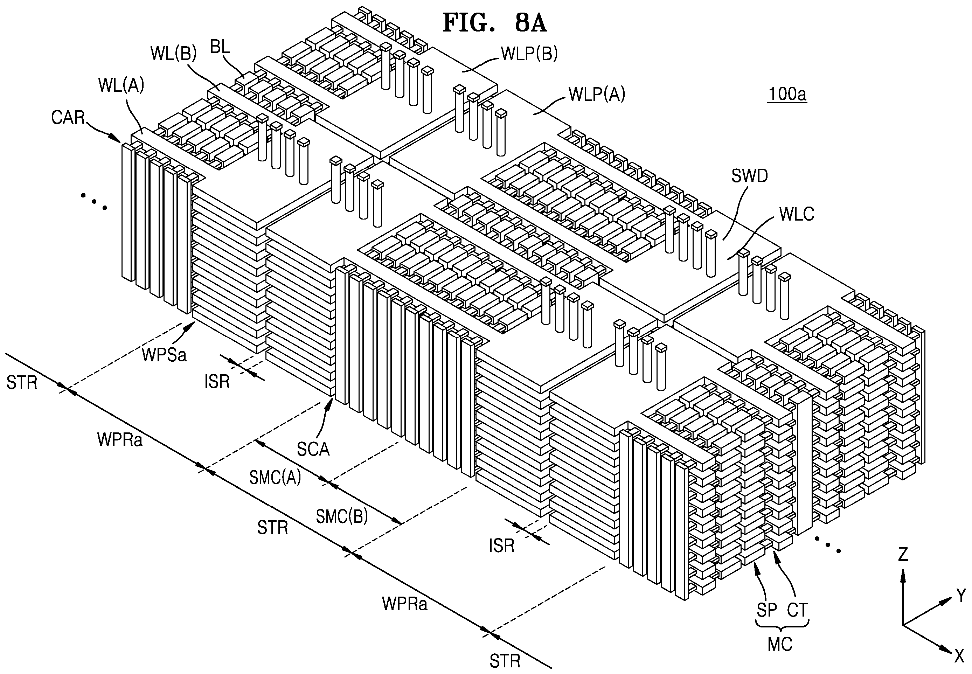

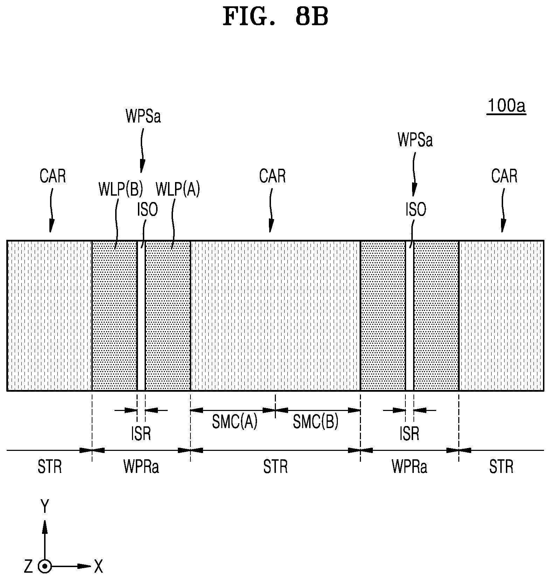

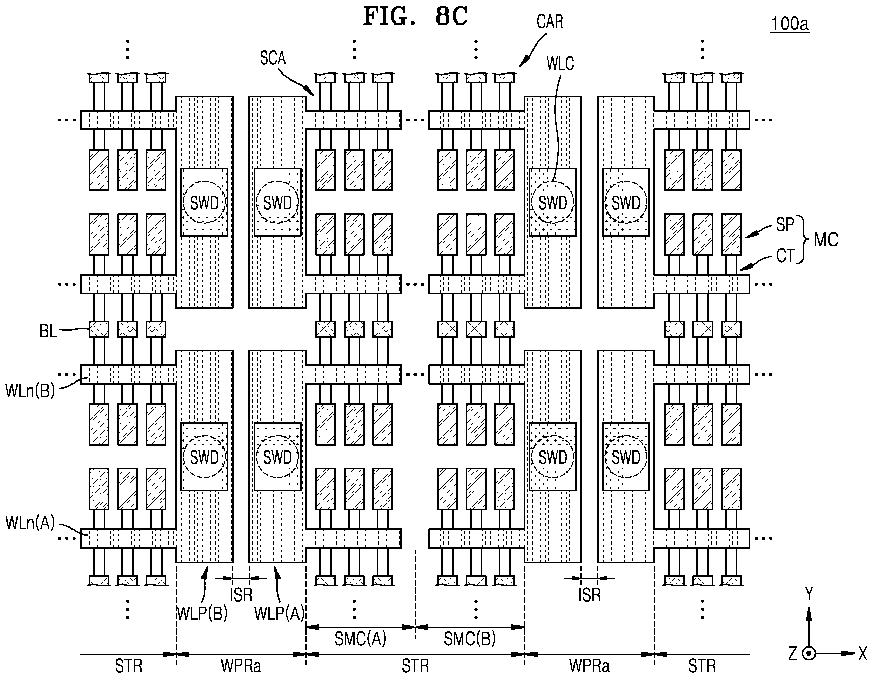

FIG. 8A is a perspective view of a semiconductor memory device according to embodiments, FIG. 8B is a plan view illustrating a part of a semiconductor memory device, according to embodiments, and FIG. 8C is a plan view of a semiconductor memory device according to embodiments.

Referring to FIG. 8A, a semiconductor memory device 100a may include a plurality of stack regions STR and a plurality of pad regions WPRa. A stacked cell array structure CAR may be located in each of the stack regions STR. A pad structure WPSa may be located in each of the pad regions WPRa. The stacked cell array structure CAR may include a plurality of sub-cell arrays SCA.

A plurality of sub-cell arrays SCA included in one stacked cell array structure CAR may be arranged in the second horizontal direction (the Y direction). A sub-cell array SCA may include a plurality of bit lines BL, a plurality of word lines WL, and a plurality of memory cells MC. Each of the memory cells MC may include a cell transistor CT and an information storage element SP. The cell transistor CT may include a semiconductor pattern 110.

Two pad structures WPSa separated from each other in the first horizontal direction (the X direction) may be arranged in each pad region WPRa. Each of the two pad structures WPSa may include a plurality of word line pads WLP spaced apart from each other in the vertical direction (the Z direction). The pad region WPRa may have an isolation insulating region ISR between the two pad structures WPSa separated from each other in the first horizontal direction (the X direction). The word line pads WLP of one of the two pad structures WPSa in the pad region WPRa may be connected to memory cells MC in one stack region STR (e.g. one adjacent stack region STR) and the word line pads WLP of the other pad structure WPSa in the pad region WPRa may be connected to memory cells MC in another stack region STR (e.g. another adjacent stack region STR). The two pad structures WPSa in the pad region WPRa may be separated from each other by the isolation insulating region ISR. One word line pad WLP may be connected to two word lines WL, e.g., a first word line WL(A) and a second word line WL(B), which are at the same vertical level and included in one stack region adjacent to the pad region WPRa in the first horizontal direction (the X direction). For example, each of a plurality of word line pads WLP included in one pad structure WPSa among the two pad structures WPSa in the pad region WPRa may be connected to two word lines WL including the first word line WL(A) and the second word line WL(B), which are at the same vertical level and arranged in a stack region STR at one side of the pad region WPRa, and each of a plurality of word line pads WLP included in the other pad structure WPSa may be connected to the first word line WL(A) and the second word line WL(B), which are at the same vertical level and arranged in a stack region STR at an opposite side of the pad region WPRa.

A word line contact WLC may be connected to a word line pad WLP. The word line contact WLC may be in contact with a word line pad WLP electrically connected thereto among word line pads WLP spaced apart from each other in the vertical direction (the Z direction) and may pass through a word line pad WLP above the word line pad WLP electrically connected thereto. The word line pad WLP may be connected to a sub-word line driver SWD through the word line contact WLC.

The sub-word line driver SWD may activate a word line WL connected to a memory cell MC and thus select the memory cell MC together with a bit line BL. For example, the sub-word line driver SWD may activate the first word line WL(A) through the word line pad WLP and thus select a memory cell MC connected to the first word line WL(A) together with a bit line BL adjacent to the first word line WL(A) and may activate the second word line WL(B) through the word line pad WLP and thus select a memory cell MC connected to the second word line WL(B) together with a bit line BL adjacent to the second word line WL(B). Accordingly, the first word line WL(A) and the second word line WL(B), which are connected to one word line pad WLP, may share the word line pad WLP and the word line contact WLC and the sub-word line driver SWD, which are connected to the word line pad WLP.

A plurality of memory cells MC may be divided into a first sub-memory cell group SMC(A) and a second sub-memory cell group SMC(B). Each of the memory cells MC of the first sub-memory cell group SMC(A) may be electrically connected to a sub-word line driver SWD through a word line WL and a word line pad WLP of a pad structure WPSa in a pad region WPRa adjacent to the first sub-memory cell group SMC(A). Each of the memory cells MC of the second sub-memory cell group SMC(B) may be electrically connected to a sub-word line driver SWD through the word line WL and a word line pad WLP of another pad structure WPSa in another pad region WPRa adjacent to the second sub-memory cell group SMC(B). The word line pad WLP connected to the memory cells MC in the first sub-memory cell group SMC(A) may be referred to as a first word line pad WLP(A). The word line pad WLP connected to the memory cells MC in the second sub-memory cell group SMC(B) may be referred to as a second word line pad WLP(B).

Referring to FIG. 8B, the semiconductor memory device 100a may include a plurality of stack regions STR and a plurality of pad regions WPRa. A stacked cell array structure CAR may be located in each of the stack regions STR. A pad structure WPSa including a word line pad WLP may be located in each of the pad regions WPRa. The stack regions STR may be alternately arranged with the pad regions WPRa in the first horizontal direction (the X direction). The stack regions STR may be spaced apart from each other in the first horizontal direction (the X direction) and the pad regions WPRa may be spaced apart from each other in the first horizontal direction (the X direction). For example, a pad region WPRa may be between two stack regions STR adjacent to each other in the first horizontal direction (the X direction), and a stack region STR may be between two pad regions WPRa adjacent to each other in the first horizontal direction (the X direction).

Each pad region WPRa may have the isolation insulating region ISR between two pad structures WPSa separated from each other in the first horizontal direction (the X direction) Two pad structures WPSa in one pad region WPRa may be separated from each other by the isolation insulating region ISR. An isolation insulating structure ISO may be arranged in the isolation insulating region ISR. Two pad structures WPSa in one pad region WPRa may be separated and insulated from each other by the isolation insulating structure ISO.

The stacked cell array structure CAR may include a first sub-memory cell group SMC(A) and a second sub-memory cell group SMC(B). The first sub-memory cell group SMC(A) may be adjacent to one pad region WPRa among a pair of pad regions WPRa adjacent to the stack region STR in the first horizontal direction (the X direction), and the second sub-memory cell group SMC(B) may be adjacent to the other pad region WPRa among the pair of pad regions WPRa adjacent to the stack region STR in the first horizontal direction (the X direction). The first sub-memory cell group SMC(A) may be connected to a pad structure WPSa including first word line pads WLP(A) among the two pad structures WPSa in one pad region WPRa adjacent to the first sub-memory cell group SMC(A), and the second sub-memory cell group SMC(B) may be connected to a pad structure WPSa including second word line pads WLP(B) among the two pad structures WPSa in another pad region WPRa adjacent to the second sub-memory cell group SMC(B).

Referring to FIG. 8C, the semiconductor memory device 100a may include a plurality of stack regions STR and a plurality of pad regions WPRa. A stacked cell array structure CAR may include a first sub-memory cell group SMC(A) and a second sub-memory cell group SMC(B). A sub-cell array SCA may include a plurality of word lines WL, a plurality of bit lines BL, and a plurality of memory cells MC between the word lines WL and the bit lines BL. Each of the memory cells MC may include a cell transistor CT and an information storage element SP.

Two pad structures WPSa separated from each other in the first horizontal direction (the X direction) may be arranged in each pad region WPRa. The pad region WPRa may have an isolation insulating region ISR between the two pad structures WPSa separated from each other in the first horizontal direction (the X direction).

Memory cells MC in the first sub-memory cell group SMC(A) may be connected to a first word line pad WLP(A) of one pad structure WPSa, which is located in a pad region WPRa adjacent to the first sub-memory cell group SMC(A), through a first word line WLn(A) or a second word line WLn(B), and memory cells MC in the second sub-memory cell group SMC(B) may be connected to a second word line pad WLP(B) of another pad structure WPSa, which is located in another pad region WPRa adjacent to the second sub-memory cell group SMC(B), through a first word line WLn(A) or a second word line WLn(B). The first word line pad WLP(A) and the second word line pad WLP(B) may be electrically connected to different sub-word line drivers SWD.

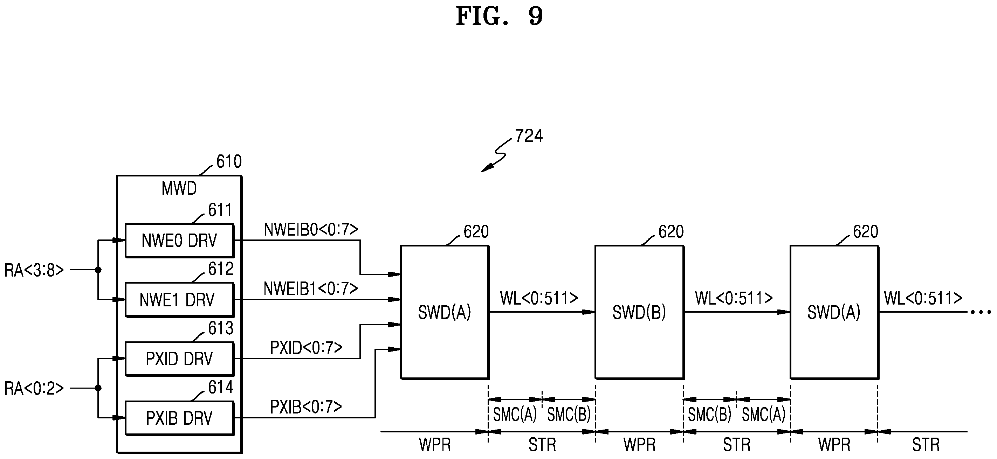

FIG. 9 is a block diagram of a row decoder included in a semiconductor memory device, according to embodiments.

Referring to FIG. 9, a row decoder 724 may select a word line WL corresponding to a row address RA. The row decoder 724 may be arranged in the upper structure UST, as shown in FIG. 4B. In the present embodiment, the row decoder 724 may select between 512 word lines according to the configuration of nine row address signals RA<0:8>. However, inventive concepts are not limited thereto, and various numbers of word lines may be selected. For example, the row decoder 724 may select between 1024 word lines WL according to the configuration of ten row address signals RA<0:9> or 2048 word lines WL according to the configuration of eleven row address signals RA<0:10>.

The row decoder 724 may include a main word line driver circuit 610 and a sub-word line driver circuit 620. The main word line driver circuit 610 may include first and second main word line drive signal generation circuits 611 and 612 and first and second sub-word line drive signal generation circuits 613 and 614. The main word line driver circuit 610 may generate a first main word line drive signal NWEIB0<0:7> and a second main word line drive signal NWEIB1<0:7>, based on signals in a most significant bit (MSB) group among the row address signals RA<0:8>. The signals in the MSB group among the row address signals RA<0:8> may be set as a row address RA<3:8>. The row address RA<3:8> may be divided into a row address RA<6:8> (hereinafter, referred to as "RA678 row address"), which correspond to an upper bit group, and a row address RA<3:5> (hereinafter, referred to as "RA345 row address"), which correspond to a lower bit group.

In some embodiments, the first main word line drive signal generation circuit 611 may generate the first main word line drive signal NWEIB0<0:7> by decoding the RA678 row address, and the second main word line drive signal generation circuit 612 may generate the second main word line drive signal NWEIB1<0:7> by decoding the RA345 row address. In the present embodiment, the main word line driver circuit 610 may divide MSB signals RA<3:8> among the row address signals RA<0:8> into two groups (e.g., RA678 and RA345) and generate eight first main word line drive signals NWEIB0<0:7> and eight second main word line drive signals NWEIB1<0:7>, based on the two groups. In other embodiments, the main word line driver circuit 610 may change decoding that generates multiple main word line drive signals NWEIB n-1 (where "n" is a natural number) based on the numbers of bits (e.g., 5, 6, and 7) in MSB group signals among row address signals, according to the configuration of various numbers of word lines (e.g., 1024 and 2048).

The second main word line drive signal generation circuit 612 may include eight circuits respectively outputting the bits in the second main word line drive signal NWEIB1<0:7>, in correspondence to a decoded RA345<0:7> row address signal. Because the configuration of the decoded RA345<0:7> row address signal has eight cases (e.g., 000, 001, 010, 011, 100, 101, 110, and 111), the activated second main word line drive signal NWEIB1<0:7> may also have eight cases. In other words, according to the decoded RA345<0:7> row address signal, one of signals NWEIB1<0>, NWEIB1<1>, NWEIB1<2>, NWEIB1<3>, NWEIB1<4>, NWEIB1<5>, NWEIB1<6>, and NWEIB1<7> may be activated to a logic low level. The second main word line drive signal NWEIB1<0:7> at the logic low level may have a ground voltage (VSS) level and may be provided to the sub-word line driver circuit 620 connected to each of memory blocks BLK1 to BLKi.

The main word line driver circuit 610 may generate a first sub-word line drive signal PXID<0:7> and a second sub-word line drive signal PXIB<0:7>, based on signals in a least significant bit (LSB) group among the row address signals RA<0:8>. The signals in the LSB group among the row address signals RA<0:8> may be set as a row address RA<0:2> (hereinafter, referred to as "RA012 row address") The main word line driver circuit 610 may include the first sub-word line drive signal generation circuit 613, which generates the first sub-word line drive signal PXID<0:7> by decoding the RA012 row address, and the second sub-word line drive signal generation circuit 614, which generates the second sub-word line drive signal PXIB<0:7> by decoding the RA012 row address.

In the present embodiment, the main word line driver circuit 610 may generate eight first sub-word line drive signals PXID<0:7> and eight second sub-word line drive signals PXIB<0:7>, based on LSB signals RA<0:2> among the row address signals RA<0:8>. However, this is just an example for clear understanding and should not be construed as limiting inventive concepts.

The first sub-word line drive signal generation circuit 613 may include eight circuits respectively outputting the bits in the first sub-word line drive signal PXID<0:7>, in correspondence to a decoded RA012<0:7> row address signal. Because the configuration of the decoded RA012<0:7> row address signal has eight cases (e.g., 000, 001, 010, 011, 100, 101, 110, and 111), the activated first sub-word line drive signal PXID<0:7> may also have eight cases. In other words, according to the decoded RA012<0:7> row address signal, one of signals PXID<0>, PXID<1>, PXID<2>, PXID<3>, PXID<4>, PXID<5>, PXID<6>, and PXID<7> may be activated to a logic high level. The first sub-word line drive signal PXID<0:7> at the logic high level may have a high voltage (VPP) level (e.g. a first voltage level that is greater than the ground voltage level) and may be provided to the sub-word line driver circuit 620 connected to each of the memory blocks BLK1 to BLKi.

The second sub-word line drive signal generation circuit 614 may include eight circuits respectively outputting the bits in the second sub-word line drive signal PXIB<0:7>, in correspondence to the decoded RA012<0:7> row address signal. Because the configuration of the decoded RA012<0:7> row address signal has eight cases (e.g., 000, 001, 010, 011, 100, 101, 110, and 111), the activated second sub-word line drive signal PXIB<0:7> may also have eight cases. In other words, according to the decoded RA012<0:7> row address signal, one of signals PXIB<0>, PXIB<1>, PXIB<2>, PXIB<3>, PXIB<4>, PXIB<5>, PXIB<6>, and PXIB<7> may be activated to a logic low level. The second sub-word line drive signal PXIB<0:7> at the logic low level may have the VSS level and may be provided to the sub-word line driver circuit 620 connected to each of the memory blocks BLK1 to BLKi.

The sub-word line driver circuit 620 may include a first sub-word line driver SWD(A) and a second sub-word line driver SWD(B). For example, the first sub-word line driver SWD(A) and the second sub-word line driver SWD(B) may be alternately arranged in one direction.

Each of a plurality of word lines WL<0:511> may be electrically connected to a plurality of sub-word line drivers SWD respectively located in a plurality of pad regions WPR. Each of the word lines WL<0:511> may be connected to a first sub-memory cell group SMC(A) and a second sub-memory cell group SMC(B), which are located in a stack region STR. The first sub-word line driver SWD(A) may be connected to a word line WL through one pad region WPR, and the second sub-word line driver SWD(B) may be connected to another word line WL through another pad region WPR. Among the word lines WL<0:511>, a word line WL selected by the first sub-word line driver SWD(A) may select the first sub-memory cell group SMC(A), and a word line WL selected by the second sub-word line driver SWD(B) may select the second sub-memory cell group SMC(B). In other words, one word line WL may be connected to at least a pair of sub-word line driver circuits 620 including the first sub-word line driver SWD(A) and the second sub-word line driver SWD(B), the first sub-memory cell group SMC(A) connected to the word line WL may be selected by the first sub-word line driver SWD(A), and the second sub-memory cell group SMC(B) connected to the word line WL may be selected by the second sub-word line driver SWD(B).

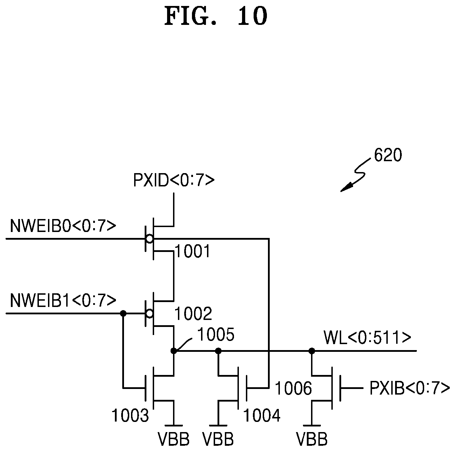

FIG. 10 is a circuit diagram of the sub-word line driver circuit 620 in FIG. 9.

Referring to FIG. 10, the sub-word line driver circuit 620 may include first to fifth transistors 1001, 1002, 1003, 1004, and 1006. The first and second transistors 1001 and 1002 may be connected in series between the line of the first sub-word line drive signal PXID<0:7> and a connection node 1005 among the second to fourth transistors 1002, 1003, and 1004. The line of the first main word line drive signal NWEIB0<0:7> may be connected to the gate of the first transistor 1001 and the line of the second main word line drive signal NWEIB1<0:7> may be connected to the gate of the second transistor 1002. The third and fourth transistors 1003 and 1004 may be connected in parallel between the connection node 1005 of the second to fourth transistors 1002 to 1004 and a negative voltage (VBB) line. The second main word line drive signal NWEIB1<0:7> may be applied to the gate of the third transistor 1003, and the first main word line drive signal NWEIB0<0:7> may be applied to the gate of the fourth transistor 1004. The fifth transistor 1006 may include an n-channel metal-oxide semiconductor (NMOS) transistor, which has a source connected to the VBB line, a drain connected to the connection node 1005 of the second to fourth transistors 1002 to 1004, and a gate to which the second sub-word line drive signal PXIB<0:7> is applied. The connection node 1005 of the second to fourth transistors 1002 to 1004 may be connected to the word lines WL<0:511> of the memory blocks BLK1 to BLKi. For instance, the connection node 1005 of one circuit may be connected to one of the word lines WL<0:511> of the memory blocks BLK1 to BLKi. The first to fourth transistors 1001 to 1004 of the sub-word line driver circuit 620 may be formed as a NOR logic circuit.

The sub-word line driver circuit 620 may include 512 circuits respectively connected to the word lines WL<0:511> in correspondence to the first main word line drive signal NWEIB0<0:7>, the second main word line drive signal NWEIB1<0:7>, the first sub-word line drive signal PXID<0:7>, and the second sub-word line drive signal PXIB<0:7> The sub-word line driver circuit 620 may select and activate one of the word lines WL<0:511> to a logic high level in response to the logic low level of the activated first main word line drive signal NWEIB0<0:7>, the logic low level of the activated second main word line drive signal NWEIB1<0:7>, the logic high level of the activated first sub-word line drive signal PXID<0:7>, and the logic low level of the activated second sub-word line drive signal PXIB<0:7>. The word line WL selected from the word lines WL<0:511> may be activated to a high voltage level that the first sub-word line drive signal PXID<0:7> at the logic high level has.

FIG. 11 is an equivalent circuit diagram of a memory cell array of a semiconductor memory device, according to embodiments.

Referring to FIG. 11, a memory cell array of a semiconductor memory device 1a may include a plurality of sub-cell arrays SCA. Each sub-cell array SCA may include a plurality of bit lines BLa, a plurality of word lines WL, and a plurality of memory cells MC. Each of the memory cells MC may include a cell transistor CT and an information storage element SP. One cell transistor CT may be arranged between one word line WL and one bit line BLa. The plurality of sub-cell arrays SCA may be arranged in the second horizontal direction (the Y direction).

The plurality of word lines WL may extend in the first horizontal direction (the X direction). Word lines WL of one sub-cell array SCA may be spaced apart from each other in the vertical direction (the Z direction). Each bit line BLa may extend in the vertical direction (the Z direction). Bit lines BLa of one sub-cell array SCA may be spaced apart from each other in the first horizontal direction (the X direction).

The gate of the cell transistor CT may be connected to a word line WL, and the source region of the cell transistor CT may be connected to a bit line BLa. The information storage element SP may be connected to the drain region of the cell transistor CT.

In some embodiments, the source region and the drain region of the cell transistor CT and the information storage element SP may be arranged from a bit line BLa, which is connected to the source region of the cell transistor CT, in the second horizontal direction (the Y direction) or the opposite direction to the second horizontal direction (the Y direction). The source and drain regions of cell transistors CT, which are respectively connected to two bit lines BLa adjacent to each other in the second horizontal direction (the Y direction), and information storage elements SP may be arranged in opposite directions from each other. For example, the source and drain regions of a cell transistor CT, which is connected to one of two bit lines BLa adjacent to each other in the second horizontal direction (the Y direction), and an information storage element SP connected to the cell transistor CT may be sequentially arranged in the second horizontal direction (the Y direction), and the source and drain regions of a cell transistor CT, which is connected to the other bit line BLa, and an information storage element SP connected to the cell transistor CT may be arranged in the opposite direction to the second horizontal direction (the Y direction). For example, the plurality of bit lines BLa may include a first bit line, a second bit line, a third bit line, and a fourth bit line, which are sequentially adjacent to each other in the second horizontal direction (the Y direction). For instance, the first bit line, the second bit line, the third bit line, and the fourth bit line may be arranged in a row along the second horizontal direction (the Y direction). A memory cell MC may not be arranged between the first bit line and the second bit line. Two memory cells MC may be arranged at the same vertical level between the second bit line and the third bit line in the second horizontal direction (the Y direction). A memory cell MC may not be arranged between the third bit line and the fourth bit line.

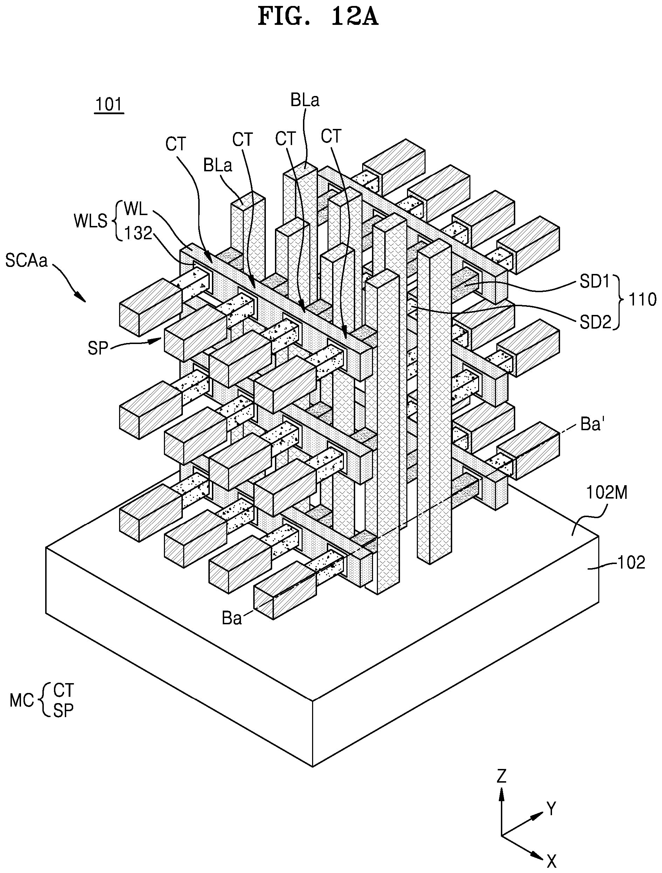

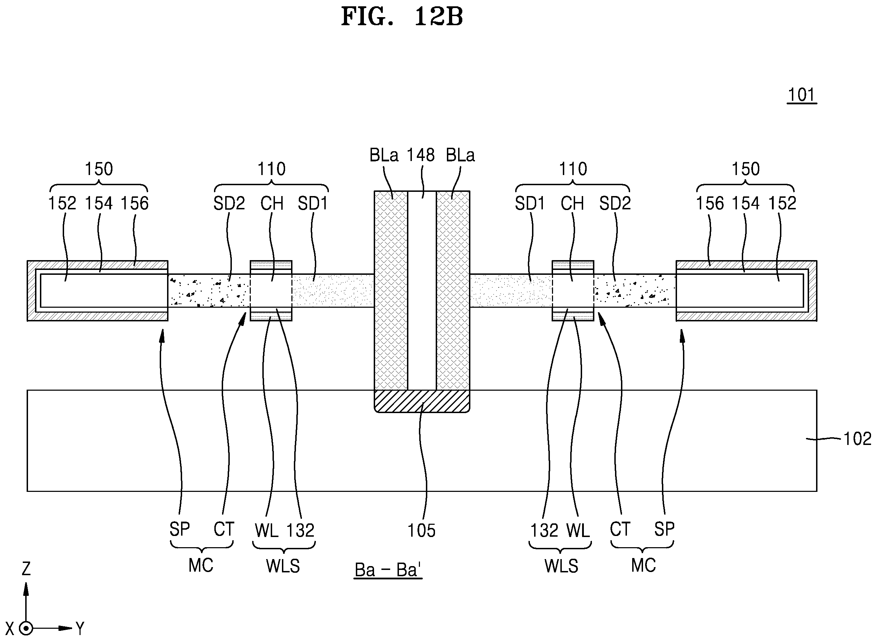

FIGS. 12A and 12B are respectively a perspective view and a cross-sectional view of a part of a semiconductor memory device, according to embodiments. In detail, FIG. 12B is a cross-sectional view taken along line Ba-Ba' in FIG. 12A.

Referring to FIGS. 12A and 12B, a semiconductor memory device 101 may include the substrate 102 and a plurality of sub-cell arrays SCAa. The sub-cell arrays SCAa may be arranged in the second horizontal direction (the Y direction). Each of the sub-cell arrays SCAa may include the substrate 102, a plurality of word lines WL, which are separated from the main surface 102M of the substrate 102 and above the substrate 102, a plurality of bit lines BLa extending from the main surface 102M of the substrate 102 in the vertical direction (the Z direction), a plurality of cell transistors CT between the word lines WL and the bit lines BL, and a plurality of information storage elements SP connected to the cell transistors CT. The plurality of cell transistors CT and the plurality of information storage elements SP may form a plurality of memory cells MC.

The word lines WL may above the substrate 102 and extend in the first horizontal direction (the X direction) and may be spaced apart from each other in the second horizontal direction (the Y direction) and the vertical direction (the Z direction). The bit lines BLa may extend from the substrate 102 in the vertical direction (the Z direction) and may be spaced apart from one another in the first horizontal direction (the X direction) and the second horizontal direction (the Y direction).

One cell transistor CT may be between one word line WL and one bit line BLa. An information storage element SP may be connected to the cell transistor CT. The cell transistor CT and the information storage element SP may be sequentially arranged from the bit line BLa connected to the cell transistor CT in the second horizontal direction (the Y direction) or the opposite direction to the second horizontal direction (the Y direction).

A source region SD1, a channel region CH, and a drain region SD2 may be sequentially arranged from a bit line BLa in the second horizontal direction (the Y direction) or in the opposite direction to the second horizontal direction (the Y direction). Two sub-cell arrays SCAa adjacent to each other in the second horizontal direction (the Y direction) may not share bit lines BLa. The source region SD1, the channel region CH, and the drain region SD2 of a cell transistor CT connected to one of two bit lines BLa, which are adjacent to each other in the second horizontal direction (the Y direction), and an information storage element SP may be arranged in an opposite direction to a direction, in which the source region SD1, the channel region CH, and the drain region SD2 of another cell transistor CT connected to the other bit line BLa and an information storage element SP are arranged.

For example, the source region SD1, the channel region CH, and the drain region SD2 of a cell transistor CT connected to one of two bit lines BLa, which are adjacent to each other in the second horizontal direction (the Y direction), and an information storage element SP may be sequentially arranged in the second horizontal direction (the Y direction), and the source region SD1, the channel region CH, and the drain region SD2 of another cell transistor CT connected to the other bit line BLa and an information storage element SP may be arranged in the opposite direction to the second horizontal direction (the Y direction).

The isolation insulating layer 105 may be between the substrate 102 and the bit lines BLa. The bit lines BLa may be separated from the substrate 102 by the isolation insulating layer 105. The isolation insulating layer 105 may electrically insulate the bit lines BLa from the substrate 102. At least a portion of the isolation insulating layer 105 may be embedded in the substrate 102. The isolation insulating layer 105 may be separated from a semiconductor pattern 110. For example, the top surface of the isolation insulating layer 105 may be at a lower vertical level than the bottom surface of the semiconductor pattern 110 at the bottom. The vertical level of top surface of the isolation insulating layer 105 may be equal to or higher than the vertical level of the top surface of the substrate 102.

A pair of bit lines BLa adjacent to each other in the second horizontal direction (the Y direction) may be disposed on one isolation insulating layer 105. The pair of bit lines BLa on one isolation insulating layer 105 may be separated from each other by an insulating structure 148. The pair of bit lines BLa adjacent to each other in the second horizontal direction (the Y direction) and the insulating structure 148 filling between the bit lines BLa may be disposed on one isolation insulating layer 105. The sum of the widths of the pair of pair of bit lines BLa adjacent to each other in the second horizontal direction (the Y direction) and the width of the insulating structure 148 between the bit lines BLa may be substantially the same as the width of the isolation insulating layer 105 in the second horizontal direction (the Y direction).

In some embodiments, an information storage element SP may correspond to a capacitor structure 150 including a first electrode 152, a second electrode 156, and a capacitor dielectric film 154 between the first electrode 152 and the second electrode 156. The capacitor structure 150 may include the first electrode 152 connected to the drain region SD2 and extending in the second horizontal direction (the Y direction), the capacitor dielectric film 154 covering the first electrode 152, and the second electrode 156 covering the capacitor dielectric film 154. The second electrode 156 may be connected to a ground wire PP in FIG. 11 or may be a part of the ground wire PP.

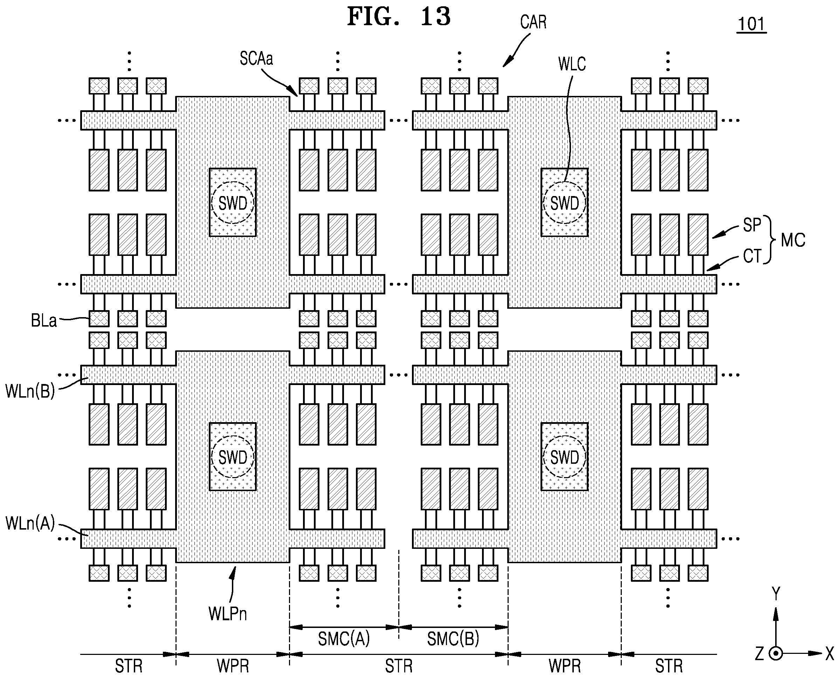

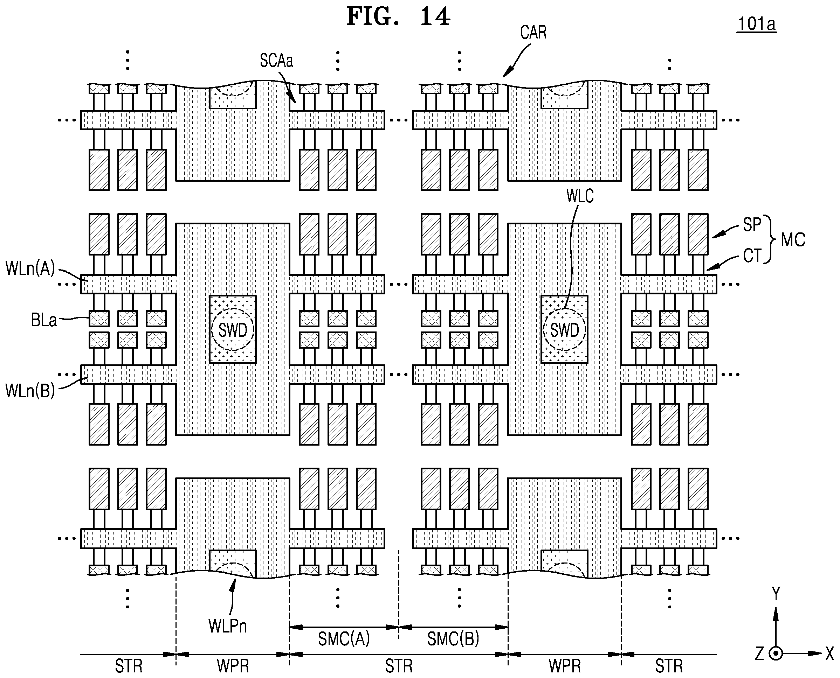

FIGS. 13 and 14 are plan views each illustrating a part of the semiconductor memory device 101, according to embodiments.

Referring to FIG. 13, the semiconductor memory device 101 may include a plurality of stack regions STR and a plurality of pad regions WPR. A stacked cell array structure CAR may include a plurality of sub-cell arrays SCAa. The stack regions STR may be alternately arranged with the pad regions WPR in the first horizontal direction (the X direction). The stacked cell array structure CAR may include a first sub-memory cell group SMC(A), which is adjacent to one pad region WPR in a pair of pad regions WPR adjacent to a stack region STR, and a second sub-memory cell group SMC(B) adjacent to the other pad region WPR.

Each of the sub-cell arrays SCAa may include a plurality of word lines WL, a plurality of bit lines BLa, and a plurality of memory cells MC between the word lines WL and the bit lines BLa. Each of the memory cells MC may include a cell transistor CT and an information storage element SP.

The bit lines BLa may include a bit line column of bit lines BLa, which are spaced apart from each other in the first horizontal direction (the X direction). A plurality of bit line columns may be spaced apart from each other in the second horizontal direction (the Y direction). Each bit line column may be arranged along a line extending to a stack region STR in the first horizontal direction (the X direction) between two word line pads WLPn adjacent to each other in the second horizontal direction (the Y direction) at the same vertical level. In some embodiments, in a plan view, a pair of bit line columns and a pair of word lines WL may be repeatedly arranged in the second horizontal direction (the Y direction). A pair of word lines WL adjacent to each other in the second horizontal direction (the Y direction) may include a first word line WLn(A) and a second word line WLn(B), which are connected to one word line pad WLPn. In a plan view, a bit line BLa may not be arranged between the first word line WLn(A) and the second word line WLn(B), which are connected to one word line pad WLPn. Instead, the bit BL lines may be located between word lines WL connected to adjacent word line pads WLPn in the second horizontal direction (the Y direction). For instance, a pair of bit line columns may be located between a pair of word lines WL connected to a pair of word line pads WLPn that are adjacent to each other in the second horizontal direction (the Y direction). Referring to FIG. 14, a semiconductor memory device 101a may include a plurality of stack regions STR and a plurality of pad regions WPR. A stacked cell array structure CAR may include a plurality of sub-cell arrays SCAa. The stack regions STR may be alternately arranged with the pad regions WPR in the first horizontal direction (the X direction). The stacked cell array structure CAR may include a first sub-memory cell group SMC(A), which is adjacent to one pad region WPR in a pair of pad regions WPR adjacent to a stack region STR, and a second sub-memory cell group SMC(B) adjacent to the other pad region WPR.

Each of the sub-cell arrays SCAa may include a plurality of word lines WL, a plurality of bit lines BLa, and a plurality of memory cells MC between the word lines WL and the bit lines BLa. Each of the memory cells MC may include a cell transistor CT and an information storage element SP.

The bit lines BLa may include a bit line column of bit lines BLa, which are spaced apart from each other in the first horizontal direction (the X direction). A plurality of bit line columns may be spaced apart from each other in the second horizontal direction (the Y direction). Each of the bit line columns may be arranged in the first horizontal direction (the X direction) between two word line pads WLPn adjacent to each other in the first horizontal direction (the X direction). In some embodiments, in a plan view, a pair of bit line columns and a pair of word lines WL may be repeatedly arranged in the second horizontal direction (the Y direction). A pair of word lines WL adjacent to each other in the second horizontal direction (the Y direction) may include a first word line WLn(A) and a second word line WLn(B), which are connected to one word line pad WLPn. In a plan view, a bit line BLa may be arranged between the first word line WLn(A) and the second word line WLn(B), which are connected to one word line pad WLPn. For example, in a plan view, a pair of bit line columns may be arranged between the first word line WLn(A) and the second word line WLn(B), which are connected to one word line pad WLPn. In a plan view, a bit line BLa may not be arranged between a pair of word lines WL connected to a pair of word line pads WLPn that are adjacent to each other in the second horizontal direction (the Y direction).

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While some embodiments inventive concepts have been particularly shown and described, it will be understood that various changes in form and details may be made therein without departing from the scope of the following claims.

## Claims

1. A semiconductor memory device comprising:
a substrate (102) including a stack region (STR) and a pad region (WPR) in a first horizontal direction;
a plurality of word lines (WL) extending in the first horizontal direction in the stack region (STR) and spaced apart from each other in a vertical direction, the plurality of word lines (WL) including a first word line and a second word line at a same vertical level, the first word line and the second word line being separated from each other in a second horizontal direction, the second horizontal direction being different from the first horizontal direction;
a plurality of bit lines (BL) extending in the vertical direction in the stack region (STR) and spaced apart from one another in the first horizontal direction and the second horizontal direction;
a plurality of memory cells (MC) in the stack region (STR), the plurality of memory cells (MC) being between the plurality of word lines (WL) and the plurality of bit lines (BL); and
a pad structure (WPS) including a plurality of word line pads (WLP) spaced apart from each other in the vertical direction in the pad region (WPR), wherein
each of the plurality of word line pads (WLP) is connected to the first word line and the second word line at the same vertical level.

2. The semiconductor memory device of claim 1, further comprising:
a plurality of word line contacts (WLC) in the pad region (WPR) and electrically connected to the plurality of word line pads (WLP), respectively; and
a plurality of sub-word line drivers respectively connected to the plurality of word line contacts (WLC),
wherein the plurality of memory cells (MC) are arranged at a cell pitch in the second horizontal direction, and
wherein a contact horizontal width corresponding to a width of each of the plurality of word line contacts (WLC) in the second horizontal direction is greater than the cell pitch.

3. The semiconductor memory device of claim 1 or claim 2, wherein
the stack region (STR) includes a first stack region and a second stack region respectively at opposite sides of the pad region (WPR) in the first horizontal direction, and
each of the plurality of word line pads (WLP) is connected to the first word line and the second word line, which are arranged at the same vertical level in each of the first stack region and the second stack region.

4. The semiconductor memory device of any preceding claim, wherein
a width of each of the plurality of word line pads (WLP) in the second horizontal direction is greater than a distance in the second horizontal direction between one side surface of the first word line among both side surfaces thereof and one side surface of the second word line among both side surfaces thereof,
the one side surface of the first word line is opposite to the one side surface of the second word line, and
the first word line and the second word line are connected to each of the plurality of word line pads (WLP).

5. The semiconductor memory device of any preceding claim, wherein
the plurality of bit lines (BL) include bit line columns spaced apart from each other in the second horizontal direction,
each of the bit line columns includes some bit lines among the plurality of bit lines (BL), the some bit lines being arranged in a column in the first horizontal direction,
the first word line, the second word line, and one bit line column among the bit line columns are repeatedly arranged in the second horizontal direction, and
in a plan view, the plurality of bit lines (BL) are not arranged between the first word line and the second word line, which are connected to each of the plurality of word line pads (WLP).

6. The semiconductor memory device of any of claims 1-4, wherein
the plurality of bit lines (BL) include bit line columns spaced apart from each other in the second horizontal direction,
each of the bit line columns includes some bit lines among the plurality of bit lines (BL), the some bit lines being arranged in a column in the first horizontal direction,
the first word line, the second word line, and a pair of bit line columns among the bit line columns are repeatedly arranged in the second horizontal direction, and
in a plan view, the plurality of bit lines (BL) are not arranged between the first word line and the second word line, which are connected to each of the plurality of word line pads (WLP).

7. The semiconductor memory device of any of claims 1-4, wherein
the plurality of bit lines (BL) include a plurality of bit line columns spaced apart from each other in the second horizontal direction,
each of the plurality of bit line columns includes some bit lines among the plurality of bit lines (BL), the some bit lines being arranged in a column in the first horizontal direction, and,
in a plan view, a pair of bit line columns among the plurality of bit line columns is arranged between the first word line and the second word line, which are connected to each of the plurality of word line pads (WLP).

8. The semiconductor memory device of claim 1 wherein:
the stack region (STR) is a first stack region;
the pad region (WPR) is a first pad region;
the substrate (102) includes a plurality of stack regions (STR) and a plurality of pad regions (WPR) alternately arranged with each other in the first horizontal direction, the plurality of pad regions (WPR) including the first pad region;
the plurality of stack regions (STR) include the first stack region and a second stack region respectively at opposite sides in the first horizontal direction of the first pad region;
the plurality of word lines (WL) extend in the first horizontal direction in each of the plurality of stack regions (STR);
the plurality of bit lines (BL) extend in the vertical direction in each of the plurality of stack regions (STR);
the plurality of memory cells (MC) are in each of the plurality of stack regions (STR);
a pad structure (WPS) is provided in each of the plurality of pad regions (WPR), each pad structure (WPS) including a plurality of word line pads (WLP) spaced apart from each other in the vertical direction; and
the semiconductor memory device further comprises a plurality of word line contacts (WLC) in each of the plurality of pad regions (WPR) and electrically connected to the plurality of word line pads (WLP), respectively, wherein
each of the plurality of word line pads (WLP) is connected to the first word line and the second word line at the same vertical level in at least one of the first stack region and the second stack region.

9. The semiconductor memory device of claim 8, wherein
each of the plurality of word line pads is connected to the first word line and the second word line, which are arranged at the same vertical level in each of the first stack region and the second stack region.

10. The semiconductor memory device of claim 8 or claim 9, wherein
the pad structure (WPS) includes two pad structures separated from each other in the first horizontal direction in each of the plurality of pad regions (WPR),
each of the plurality of word line pads (WLP) included in one pad structure among the two pad structures is connected to the first word line and the second word line arranged at the same vertical level in the first stack region, and
each of the plurality of word line pads (WLP) included in the other pad structure among the two pad structures is connected to the first word line and the second word line arranged at the same vertical level in the second stack region.

11. The semiconductor memory device of any of claims 8-10, wherein,
in a plan view, the plurality of bit lines (BL) are not arranged between the first word line and the second word line, which are connected to each of the plurality of word line pads (WLP).

12. The semiconductor memory device of any of claims 8-10, wherein,
in a plan view, the plurality of bit lines (BL) are arranged between the first word line and the second word line, which are connected to each of the plurality of word line pads (WLP).

13. The semiconductor memory device of any preceding claim, wherein
each of the plurality of memory cells (MC) includes a cell transistor (CT) and an information storage element (ST), and
the cell transistor (ST) includes a semiconductor pattern extending in the second horizontal direction from each of the plurality of bit lines (BL).

14. A semiconductor memory device comprising:
a lower structure; and
an upper structure on the lower structure, the upper structure including a plurality of sub-word line drivers,
wherein:
the lower structure includes a semiconductor memory device according to any of claims 8-12,
the plurality of word line contacts (WLC) electrically connect the plurality of word line pads (WLP) to the plurality of sub-word line drivers, and
each of the plurality of memory cells (MC) includes a cell transistor (CT) and an information storage element (ST),
the cell transistor (CT) includes a semiconductor pattern passing through one of the plurality of word lines (WL),
the semiconductor pattern includes a source region connected to each of the plurality of bit lines, a channel region surrounded by each of the plurality of word lines, and a drain region connected to the information storage element (ST), and
the source region, the channel region, and the drain region are sequentially arranged from each of the plurality of bit lines in the second horizontal direction.

15. The semiconductor memory device of claim 14, wherein
the plurality of memory cells (MC) are arranged at a cell pitch in the second horizontal direction,
the cell pitch is greater than a contact horizontal width corresponding to a width of each of the plurality of word line contacts (WLC) in the second horizontal direction,
a width of each of the plurality of word line pads (WLP) in the second horizontal direction is greater than a distance in the second horizontal direction between one side surface of the first word line among both side surfaces thereof and one side surface of the second word line among both side surfaces thereof,
the one side surface of the first word line is opposite the one side surface of the second word line, and
the first word line and the second word line are connected to each of the plurality of word line pads (WLP).
